# EUROPEAN PATENT APPLICATION

(11) **EP 4 734 725 A1**
(43) Date of publication of application: **29.04.2026**
(21) Application number: 25202099.5
(22) Date of filing: 15.09.2025
(51) Int. Cl.: H10K 59/80, H10K 50/86

(54) **DISPLAY DEVICE AND AUTOMOBILE INCLUDING THE SAME**

(30) Priority: 24.10.2024 KR 20240146466
(71) Applicant: Samsung Display Co., Ltd., Yongin-si, Gyeonggi-do 17113 (KR)
(72) Inventor: KIM, Hyang Yul, Giheung-gu, Yongin-si, Gyeonggi-do (KR); JUNG, Ji Won, Giheung-gu, Yongin-si, Gyeonggi-do (KR); KIM, Jae Hong, Giheung-gu, Yongin-si, Gyeonggi-do (KR); LEE, Chang Han, Giheung-gu, Yongin-si, Gyeonggi-do (KR)
(74) Representative: Dr. Weitzel & Partner

(57) **Abstract**

Provided are display device and automobile including the same. The display device may include a first substrate (110), a light emitting layer (172) on the first substrate, and a second substrate (200) on the light emitting layer and covering the light emitting layer. The second substrate may include a groove recessed in a direction from a first surface of the second substrate toward a second surface of the substrate. The second substrate further includes a louver in the groove (LV).

## Description

The present invention relates to a display device and/or an automobile including the same.

As the information society develops, demands for display devices for displaying images are increasing in various forms. The display devices may be displays such as liquid crystal displays, field emission displays, and light emitting displays. The light emitting displays may include an organic light emitting display including an organic light emitting diode element as a light emitting element and/or an inorganic light emitting display including an inorganic light emitting diode element as a light emitting element.

In the case of vehicle displays, if an image displayed on a vehicle display in front of a driver or a passenger is reflected by the windshield at night, it may interfere with the driver's driving. Therefore, it may be advantageous to control the viewing angle of the image displayed on the vehicle display. In addition, in order to protect privacy, it may be advantageous to control the viewing angle of an image displayed on the vehicle display in front of the driver so that the image displayed on the vehicle display is not provided to the passenger.

### SUMMARY

The present invention is defined by the features of claim 1. The dependent claims and the description provide preferred embodiments.

Aspects of the present invention provide a display device with improved luminance efficiency and/or an automobile including the display device.

Aspects of the present invention also provide a display device which limits or minimizes visual distortion phenomena such as moire, double image, and milky haze, and/or an automobile including the display device.

However, aspects of the present invention are not restricted to the ones set forth herein. The above and other aspects of the present invention will become more apparent to one of ordinary skill in the art to which the present invention pertains by referencing the detailed description of the present invention given below.

According to the present invention, a display device includes a base substrate, which is also termed as base member herein, a light emitting element layer on the base substrate, and an encapsulation substrate on the light emitting element layer and covering the light emitting element layer. The encapsulation substrate preferably includes a groove recessed in a direction from a first surface of the encapsulation substrate toward a second surface of the encapsulation substrate. The encapsulation substrate further includes a louver extending in a direction from the first surface of the encapsulation substrate toward the second surface of the encapsulation substrate. Thus, the louver is integrated in the encapsulation substrate as it extends within the encapsulation substrate in a thickness direction thereof. Although the louver preferably has a grid structure when seen in a plan view in the thickness direction of the encapsulation substrate, that is in a plan view on the encapsulation substrate, the louver also has an extension within the encapsulation substrate in the thickness direction of the encapsulation substrate. Preferably, the louver is in the groove. The louver may be also termed as a louver structure as it especially comprises several louvers which preferably may be connected to each other or may be formed integrally with each other.

In an embodiment, the light emitting element layer may include a first emission area respectively a plurality of first emission areas, a second emission area respectively a plurality of second emission areas and a third emission area respectively a plurality of third emission areas. When reference is made to the first emission area, the second emission area, and the third emission area, a respective one of the first, the second, and the third emission area is addressed. The third emission area, the first emission area and the second emission area may be sequentially disposed in one direction. The louver may include a first louver surrounding the third emission area in plan view and a second louver between the first emission area and the second emission area in plan view. A size of the third emission area may be larger than sizes of the first and second emission areas.

A first of the third emission areas (that is a first third emission area), the first emission area, the second emission area and a second of the third emission area (that is a second third emission area) may be sequentially disposed in the one direction.

A height of the first louver may be greater than a height of the second louver.

In an embodiment, a distance between the first emission area and a portion of the second louver between the second emission area and the first emission area may be smaller than a distance between the first emission area and a portion of the first louver between the first emission area and the third emission area. In other words, in the one direction, a distance between the first emission area and the second louver may be smaller than a distance between the first emission area and the first louver.

In an embodiment, a portion of the first louver may be between the first emission area and the third emission area, and a distance between the first emission area and the portion of the first louver may be greater than a distance between the third emission area and the portion of the first louver. In other words, in the one direction, a distance between the first emission area and the first louver may be greater than a distance between the third emission area the first louver.

In an embodiment, the size of the first emission area may be smaller than the size of the second emission area, a portion of the second louver may be between the first emission area and the second emission area, and a distance between the first emission area and the portion of the second louver between the first emission area and the second emission area may be greater than a distance between the second emission area and the portion of the second louver between the first emission area and the second emission area. In other words, in the one direction, and a distance between the first emission area and the second louver may be greater than a distance between the second emission area and the second louver.

In an embodiment, the light emitting element layer may include a first emission area, a second emission area, a third emission area, and a bank. The bank may be between the first emission area, the second emission area, and the third emission area. The louver may overlap the bank.

In an embodiment, the louver may not overlap the first emission area, the second emission area, and the third emission area.

In an embodiment, a size of the third emission area may be larger than a size of the first emission area and a size of the second emission area, and at least a portion of the louver may overlap the third emission area.

In an embodiment, the louver may not overlap the first emission area and the second emission area.

In an embodiment, the louver may include a first light blocking louver between the second emission area and the first emission area, a second light blocking louver between the first emission area and the third emission area, a third light blocking louver between the third emission area and the second emission area, and a fourth light blocking louver overlapping the third emission area.

Heights of the first light blocking louver, the second light blocking louver, the third light blocking louver, and the fourth light blocking louver may be equal to each other.

In an embodiment, a distance between the first emission area and the first light blocking louver may be equal to a distance between the first emission area and the second light blocking louver.

In an embodiment, a distance between the second emission area and the third light blocking louver may be equal to a distance between the second emission area and the first light blocking louver.

In an embodiment, a distance between the third emission area and the second light blocking louver may be equal to a distance between the third emission area and the third light blocking louver.

In an embodiment, a distance between the second light blocking louver and the fourth light blocking louver may be equal to a distance between the fourth light blocking louver and the third light blocking louver.

In an embodiment, a polarizing layer may be on the encapsulation substrate.

In an embodiment, the first surface of the encapsulation substrate may face the base substrate, and the second surface of the encapsulation substrate may face the polarizing layer.

In an embodiment, the first surface of the encapsulation substrate may face the polarizing layer, and the second surface of the encapsulation substrate may face the base substrate.

In an embodiment, the encapsulation substrate may further include an overcoat layer on the first surface, and the overcoat layer may cover the first surface and the louver.

According to an example embodiment of the present invention, a display device may include a display substrate including a base substrate, a thin-film transistor layer on the base substrate, and a light emitting element layer on the thin-film transistor layer; and an encapsulation substrate facing the display substrate. A first surface of the encapsulation substrate may be opposite a second surface of the encapsulation substrate. The encapsulation substrate may include a light control layer, and the light control layer may include a louver extending in a direction from the first surface of the encapsulation substrate toward the second surface of the encapsulation substrate.

In an embodiment, the light emitting element layer may include a first emission area, a second emission area and a third emission area. The second emission area, the first emission area and the third emission area may be sequentially disposed in one direction. The louver may include a first louver surrounding the third emission area in plan view and a second louver between the first emission area and the second emission area in plan view. A size of the third emission area may be larger than a size of the first emission area and a size of the second emission area, and a height of the first louver may be greater than a height of the second louver.

In an embodiment, the light emitting element layer may include a first emission area, a second emission area, a third emission area, and a bank. The bank may be between the first emission area, the second emission area, and the third emission area. The louver may overlap the bank.

In an embodiment, a polarizing layer may be on the encapsulation substrate.

In an embodiment, the encapsulation substrate may further include an overcoat layer on the first surface of the encapsulation substrate, and the overcoat layer may cover the first surface of the encapsulation substrate and the louver.

According to an example embodiment of the present invention, an automobile may include a windshield; a dashboard adjacent to the windshield; and at least one display device on the dashboard. The display device may include a base substrate, a light emitting element layer on the base substrate, and a encapsulation substrate on the light emitting element layer and covering the light emitting element layer. The encapsulation substrate may include a groove recessed in a direction from a first surface of the encapsulation substrate toward a second surface of the encapsulation substrate. The encapsulation substrate may further include a louver in the groove.

In an embodiment, the dashboard may include a first dashboard configured to be disposed in front of a driver's seat and a second dashboard configured to be disposed in front of a passenger seat. The display device may be on the first dashboard and the second dashboard. The display device may be connected from the first dashboard to the second dashboard.

According to a display device according to an embodiment of the present invention and an automobile including the same, luminance efficiency can be improved.

According to a display device according to an embodiment of the present invention and an automobile including the same, visual distortion phenomena such as moire, double image, and milky haze can be limited and/or minimized.

However, the effects of the present invention are not restricted to the ones set forth herein. The above and other effects of the present invention will become more apparent to one of daily skill in the art to which the present invention pertains by referencing the presented embodiments and the claims.

### BRIEF DESCRIPTION OF THE DRAWINGS

These and/or other aspects will become apparent and more readily appreciated from the following description of the embodiments, taken in conjunction with the accompanying drawings in which:
FIG. 1 is a perspective view of an example of an electronic device according to an embodiment;
FIG. 2 is a perspective view of a display device according to an embodiment;
FIG. 3 is a cross-sectional view taken along line X1-X1' of FIG. 1;
FIG. 4 is a cross-sectional view of a display device according to an embodiment;
FIG. 5 is a cross-sectional view of a display device according to an embodiment;
FIG. 6 is a diagram of a case where a display device according to an embodiment is applied to a vehicle;
FIG. 7 is a cross-sectional view of an example of a display substrate according to an embodiment;
FIG. 8 is a plan view of an example of a portion of a display area of a display device according to an embodiment;
FIG. 9 is a cross-sectional view taken along line X2-X2' of FIG. 8;
FIG. 10 is a graph illustrating luminance with respect to the viewing angle of a display device according to a comparative example;
FIG. 11 is a graph illustrating luminance with respect to the viewing angle of a display device according to an embodiment;
FIG. 12 is a cross-sectional view of a display device according to an embodiment;
FIG. 13 is a plan view of an example of a portion of a display area of a display device according to an embodiment;
FIG. 14 is a cross-sectional view taken along line X3-X3' of FIG. 13;
FIG. 15 is a cross-sectional view of a display device according to an embodiment;
FIG. 16 is a flowchart illustrating a method of manufacturing a display device according to an embodiment;
FIG. 17 is a cross-sectional view illustrating operation S110 of FIG. 16;
FIG. 18 is a cross-sectional view illustrating operation S120 of FIG. 16;
FIG. 19 is a cross-sectional view illustrating operation S130 of FIG. 16;
FIG. 20 is a cross-sectional view illustrating operation S140 of FIG. 16;
FIG. 21 is a flowchart illustrating a method of manufacturing a display device according to an embodiment;
FIG. 22 is a cross-sectional view illustrating operation S210 of FIG. 21;
FIG. 23 is a cross-sectional view illustrating operation S220 of FIG. 21;
FIG. 24 is a cross-sectional view illustrating operation S230 of FIG. 21; and
FIG. 25 is a cross-sectional view illustrating operation S240 of FIG. 21.

### DETAILED DESCRIPTION

Example embodiments will now be described more fully hereinafter with reference to the accompanying drawings, in which some example embodiments are shown. Example embodiments may, however, be embodied in different forms and should not be construed as limited to the embodiments set forth herein. Rather, these embodiments are provided so that this disclosure will be thorough and complete, and will fully convey the scope of inventive concepts to those skilled in the art.

It will also be understood that when a layer is referred to as being "on" another layer or substrate, it can be directly on the other layer or substrate, or intervening layers may also be present. The same reference numbers indicate the same components throughout the specification.

While the term "equal to" is used in the description of example embodiments, it should be understood that some imprecisions may exist. Thus, when one element is referred to as "equal to" another element, it should be understood that an element or a value may be "equal to" another element within a desired manufacturing or operational tolerance range (e.g., ±10%).

Hereinafter, embodiments of the present invention will be described in detail with reference to the accompanying drawings.

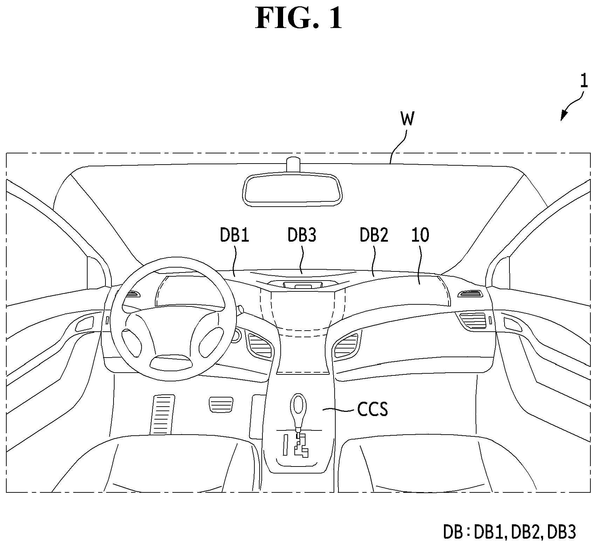

FIG. 1 is a perspective view of an example of an electronic device 1 according to an embodiment.

Referring to FIG. 1, the electronic device 1 displays moving images and/or still images. The electronic device 1 may refer to any electronic device that provides a display screen. Examples of the electronic device 1 may include a television, a notebook computer, a monitor, a billboard, an Internet of things (IoT) device, a mobile phone, a smartphone, a tablet personal computer (PC), an electronic watch, a smart watch, a watch phone, a head-mounted display, a mobile communication terminal, an electronic notebook, an electronic book, a portable multimedia player (PMP), a navigation device, a game console, a digital camera, a camcorder and an automobile, all of which provide a display screen. In FIG. 1, an automobile is shown as an example of the electronic device 1.

The electronic device 1 may include a display device 10 that provides a display screen. Examples of the display device 10 may include an inorganic light emitting diode display device, an organic light emitting display device, a quantum dot light emitting display device, a plasma display panel, and a field emission display device. A case where an organic light emitting diode display device is applied as an example of the display device 10 will be described below, but the present invention is not limited to this case, and other display devices can also be applied.

The shape of the electronic device 1 can be variously changed. For example, as illustrated in FIG. 1, when the electronic device 1 is an automobile, it may include a windshield W, a dashboard DB, and a center console CCS. The shapes of the windshield W, the dashboard DB, and the center console CCS of the electronic device 1 can be variously changed according to the shape of the automobile body.

The windshield W may be a transparent structure located in front of a driver's seat and a passenger seat. The windshield W may protect the driver and passengers from external elements while the automobile is being driven.

The dashboard DB may provide various information about a vehicle infotainment system to the driver and other passengers. The vehicle infotainment system refers to a system that provides information and entertainment to the driver and other passengers by integrating in-vehicle and external systems. The vehicle infotainment system may include devices or technologies that provide, inside a vehicle, Internet browsing, movies, games, television, social network services (SNS), and various services linked to navigation devices and mobile devices.

The dashboard DB may include a first dashboard DB1 located in front of the driver's seat, a second dashboard DB2 located in front of the passenger seat, and a third dashboard DB3 located between the first dashboard DB1 and the second dashboard.

In an embodiment, the first dashboard DB1 may include an instrument panel and the like to provide the driver with various information necessary for driving, such as speed information and automobile status information. For example, the first dashboard DB1 may include a digital cluster.

In an embodiment, the third dashboard DB3 may provide map information, music information, temperature information, etc. The third dashboard DB3 may provide various functions that can operate convenience functions that assist in driving the automobile. For example, the third dashboard DB3 may include a center information display (CID).

In an embodiment, the second dashboard DB2 may provide the above information of the first dashboard DB1 and the third dashboard DB3 to a passenger in the passenger seat. For example, the second dashboard DB2 may include a co-driver display.

The center console CCS may be disposed below the third dashboard DB3. The center console CCS may be disposed between the driver's seat and the passenger seat. In an embodiment, the center console CCS may include various functional members for controlling the way the automobile is driven, such as a gear lever, a parking brake, and a driving mode operation button. In the drawing, an analog operating method through physical manipulation of the gear lever, etc. is illustrated as an example. However, the present invention is not limited thereto. For example, since the display device 10 includes an input device such as a touch panel, a digital operating method through operation buttons, etc. displayed on the display device 10 may also be used.

The information provided on any one of the first through third dashboards DB1 through DB3 and the center console CCS is not necessarily provided only on the element. The information provided on any one of the first through third dashboards DB1 through DB3 and the center console CCS may also be provided on the other elements.

The electronic device 1 according to the embodiment may provide various information to a user through the display device 10 disposed on the first through third dashboards DB1 through DB3 and the center console CCS or may operate other elements included in the electronic device 1 based on information input by the user through the display device 10.

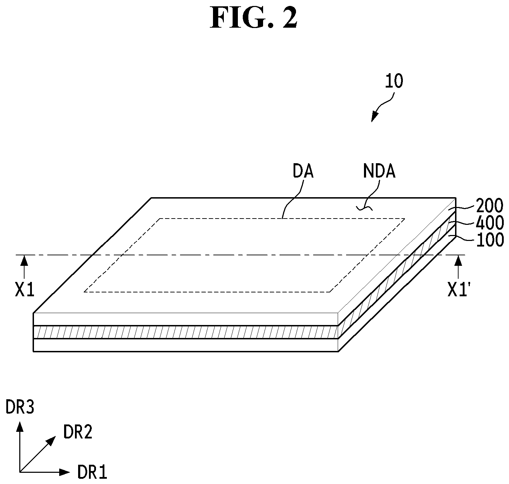

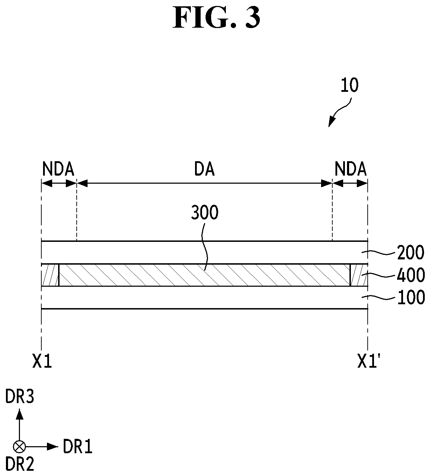

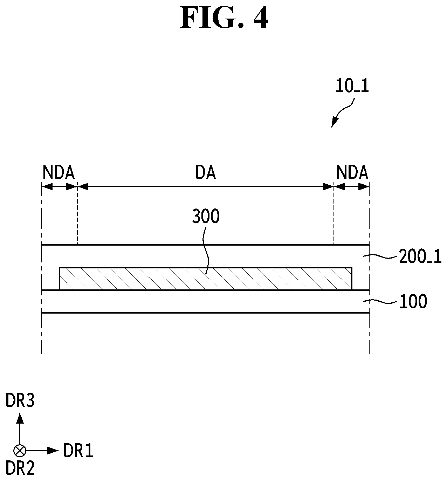

FIG. 2 is a perspective view of a display device 10 according to an embodiment. FIG. 3 is a cross-sectional view taken along line X1-X1' of FIG. 1. FIG. 4 is a cross-sectional view of a display device 10_1 according to an embodiment.

Referring to FIGS. 2 through 4 in addition to FIG. 1, in an embodiment, the display device 10 may be rectangular in plan view. The display device 10 may include two long sides extending in a first direction DR1 and two short sides extending in a second direction DR2 intersecting the first direction DR1. Each corner where a long side meets a short side may be right-angled. However, the present invention is not limited thereto, and each corner may also form a curved surface. Also, in an embodiment, the long sides alternatively may extend in the second direction DR2, and the short sides alternatively may extend in the first direction DR1.

In the drawings, the first direction DR1 and the second direction DR2 are horizontal directions intersecting each other. For example, the first direction DR1 and the second direction DR2 may be orthogonal to each other. In addition, a third direction DR3 may intersect the first direction DR1 and the second direction DR2. For example, the third direction DR3 may be a vertical direction and may be orthogonal to the first direction DR1 and the second direction DR2. Unless otherwise defined, in the present specification, a direction indicated by an arrow of each of the first through third directions DR1 through DR3 may be referred to as one side, and the opposite direction may be referred to as the other side. In addition, in the present specification, "on", "upper side", "above", "top", and "upper surface" refer to a direction in which the arrow of the third direction DR3 points in the drawings, and "under", "lower side", "below", "bottom", and "lower surface" refer to a direction opposite to the direction in which the arrow of the third direction DR3 points in the drawings.

The planar shape of the display device 10 is not limited to the above example and may also be a circular shape or other shapes. For example, as illustrated in FIG. 1, when the display device 10 is integrally disposed on the dashboard DB and the center console CCS of the electronic device 1, it may have a shape corresponding to the shape of the dashboard DB and the center console CCS.

The display device 10 may include a display area DA displaying an image and a non-display area NDA not displaying an image. In an embodiment, the non-display area NDA may be located around the display area DA and may surround the display area DA.

In an embodiment, as illustrated in FIG. 3, the display device 10 may include a display substrate 100 and an encapsulation substrate 200 facing the display substrate 100. The display device 10 may further include a sealing portion 400, which may bond the display substrate 100 and the encapsulation substrate 200 together, and a filler 300. The filler 300 may fill a space between the display substrate 100 and the encapsulation substrate 200.

The display substrate 100 may include elements and circuits for displaying an image, for example, pixel circuits such as switching elements, a pixel defining layer defining emission areas and a non-emission area, which will be described later, in the display area DA, and self-light emitting elements. In an embodiment, each of the self-light emitting elements may include at least one of an organic light emitting diode, a quantum dot light emitting diode, an inorganic material-based micro light emitting diode (e.g., micro LED), and an inorganic material-based nano light emitting diode (e.g., nano LED). For ease of description, a case where the self-light emitting elements are organic light emitting diodes will be described below as an example.

The encapsulation substrate 200 may be located on the display substrate 100 and may face the display substrate 100. In an embodiment, the encapsulation substrate 200 may transmit light emitted from the display substrate 100. In some embodiments, the encapsulation substrate 200 may include a color conversion pattern that converts the color of incident light. For example, the color conversion pattern may include at least any one of a color filter and a wavelength conversion pattern.

The sealing portion 400 may be located between the display substrate 100 and the encapsulation substrate 200 in the non-display area NDA. The sealing portion 400 may be disposed along edges of the display substrate 100 and the encapsulation substrate 200 in the non-display area NDA to surround the display area DA in plan view. The display substrate 100 and the encapsulation substrate 200 may be bonded to each other by the sealing portion 400.

In an embodiment, the sealing portion 400 may be made of an organic material. For example, the sealing portion 400 may be made of epoxy-based resin. However, the present invention is not limited thereto. In an embodiment, the sealing portion 400 may include frit.

The filler 300 may be located in the space surrounded by the sealing portion 400 between the display substrate 100 and the encapsulation substrate 200. The filler 300 may fill the space between the display substrate 100 and the encapsulation substrate 200.

In an embodiment, the filler 300 may be made of a material that can transmit light. In an embodiment, the filler 300 may be made of an organic material. For example, the filler 300 may be made of, but not limited to, a silicon-based organic material or an epoxy-based organic material. In an embodiment, the filler 300 may also be omitted.

In an embodiment, as illustrated in FIG. 4, the display device 10_1 may not include the sealing portion 400. An encapsulation substrate 200_1 may include a protruding portion disposed along the periphery of the encapsulation substrate 200_1 and protruding toward a display substrate 100 in the third direction DR3 and a recessed portion surrounded by the protruding portion. The internal space may be sealed by the display substrate 100, the encapsulation substrate 200_1, and the protruding portion. A filler 300 may fill the recessed portion.

In some embodiments, an upper surface of the display substrate 100 and a lower surface of the protruding portion of the encapsulation substrate 200_1 may be bonded together by an adhesive element. Alternatively, the upper surface of the display substrate 100 and the lower surface of the protruding portion of the encapsulation substrate 200_1 may be bonded together by a bonding method such as laser bonding.

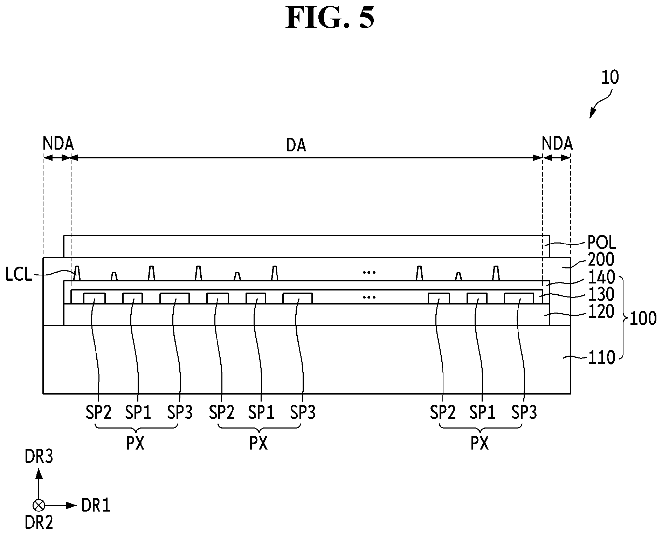

FIG. 5 is a cross-sectional view of a display device 10 according to an embodiment.

Referring to FIG. 5, the display device 10 may include a display substrate 100, an encapsulation substrate 200, and a polarizing layer POL.

The display substrate 100 may include a base member 110, a thin-film transistor layer 120, a light emitting element layer 130, and a thin-film encapsulation layer 140.

The base member 110 may include a substrate. The substrate may be made of an insulating material such as glass, quartz, or polymer resin. The polymer material may be, for example, polyethersulphone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (CAT), cellulose acetate propionate (CAP), or a combination thereof. Alternatively, the substrate may include a metal material.

The substrate may be a rigid substrate or a flexible substrate that can be bent, folded, or rolled. When the substrate is a flexible substrate, it may be made of, but not limited to, polyimide (PI).

The thin-film transistor layer 120 may be disposed on the base member 110. In the thin-film transistor layer 120, not only thin-film transistors of pixels PX, but also scan lines, data lines, power lines, scan control lines, and link lines connecting pads and the data lines may be formed. Each of the thin-film transistors may include a gate electrode, a semiconductor layer, a source electrode, and a drain electrode.

The thin-film transistor layer 120 may be disposed in a display area DA and a non-display area NDA. For example, the thin-film transistors of the pixels PX, the scan lines, the data lines, and the power lines of the thin-film transistor layer 120 may be disposed in the display area DA. The scan control lines and the link lines of the thin-film transistor layer 120 may be disposed in the non-display area NDA.

The light emitting element layer 130 may be disposed on the thin-film transistor layer 120. The light emitting element layer 130 may include the pixels PX, each including a first electrode, a light emitting layer and a second electrode, and a pixel defining layer defining the pixels PX. The light emitting layer may be an organic light emitting layer including an organic material. In this case, the light emitting layer may include a hole transporting layer, an organic light emitting layer, and an electron transporting layer. When a desired and/or alternatively predetermined voltage is applied to the first electrode and a cathode voltage is applied to the second electrode through a thin-film transistor of the thin-film transistor layer 120, holes and electrons move to the organic light emitting layer through the hole transporting layer and the electron transporting layer, respectively, and combine together in the organic light emitting layer to emit light. The pixels PX of the light emitting element layer 130 may be disposed in the display area DA.

In some embodiments, each pixel PX may include a first subpixel SP1, a second subpixel SP2, and a third subpixel SP3. Each of the first through third subpixels SP1 through SP3 may be defined as a smallest area that outputs light. The first subpixel SP1 may emit light of a first color or red light, the second subpixel SP2 may emit light of a second color or green light, and the third subpixel SP3 may emit light of a third color or blue light, but the present invention is not limited thereto. A red wavelength band may be a wavelength band of about 600 to 750 nm, a green wavelength band may be a wavelength band of about 480 to 560 nm, and a blue wavelength band may be a wavelength band of about 370 to 460 nm, but the present invention is not limited thereto.

Although the number of subpixels included in each pixel PX is three in the drawing, the present invention is not limited thereto, and the number of subpixels included in each pixel PX may also be more than three.

The thin-film encapsulation layer 140 may be disposed on the light emitting element layer 130. The thin-film encapsulation layer 140 may limit and/or prevent oxygen or moisture from permeating into the light emitting element layer 130. To this end, the thin-film encapsulation layer 140 may include at least one inorganic layer. The inorganic layer may be, but is not limited to, a silicon nitride layer, a silicon oxynitride layer, a silicon oxide layer, a titanium oxide layer, or an aluminum oxide layer. In addition, the thin-film encapsulation layer 140 may protect the light emitting element layer 130 from foreign substances such as dust. To this end, the thin-film encapsulation layer 140 may include at least one organic layer. The organic layer may be, but is not limited to, acryl resin, epoxy resin, phenolic resin, polyamide resin, or polyimide resin.

The thin-film encapsulation layer 140 may be disposed in both the display area DA and the non-display area NDA. For example, the thin-film encapsulation layer 140 may cover the light emitting element layer 130 of the display area DA and the non-display area NDA and cover the thin-film transistor layer 120 of the non-display area NDA.

The display device 10 may include the encapsulation substrate 200 having a light control layer LCL internalized therein. The encapsulation substrate 200 may be disposed on the display substrate 100. The encapsulation substrate 200 may be disposed on the base member 110 to cover the thin-film transistor layer 120, the light emitting element layer 130, and the thin-film encapsulation layer 140.

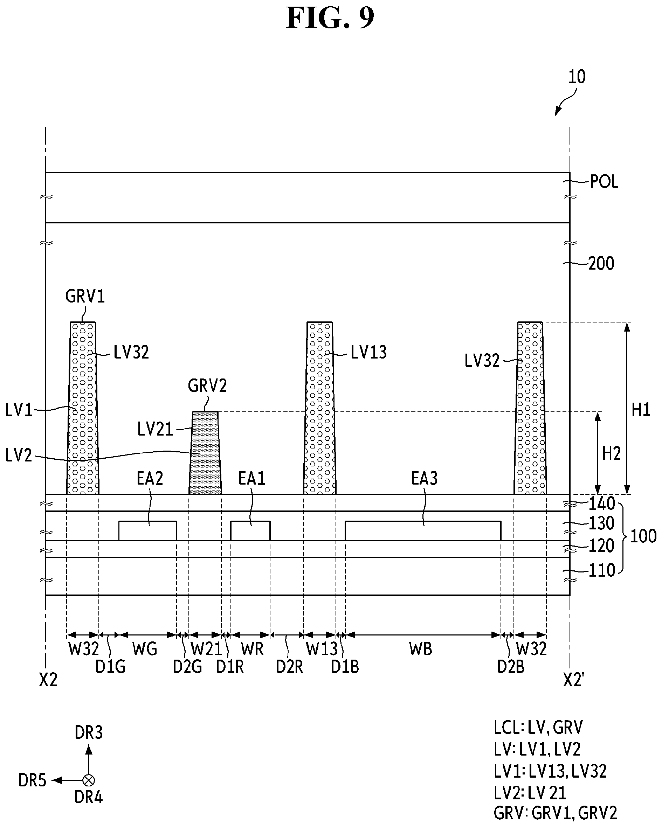

The encapsulation substrate 200 may include the light control layer LCL. The encapsulation substrate 200 may include grooves GRV (see FIG. 9) recessed in a direction from a surface of the encapsulation substrate 200 toward the other surface, for example, in a thickness direction (or the third direction DR3) and louvers LV (see FIG. 9) disposed in the grooves GRV (see FIG. 9). The grooves GRV (see FIG. 9) and the louvers LV (see FIG. 9) may be included in the light control layer LCL.

The light control layer LCL may overlap the display area DA. The light control layer LCL may absorb or block light that travels outside a certain angle to the third direction DR3 among light emitted from the light emitting element layer 130. That is, the light control layer LCL can control a viewing angle.

In the display device 10 according to the current embodiment, since the light control layer LCL is internalized in the encapsulation substrate 200, a thickness and manufacturing cost of the display device 10 can be reduced compared with when a separate light control film is attached.

The polarizing layer POL may be disposed on the encapsulation substrate 200. The polarizing layer POL may block external light reflected from the thin-film encapsulation layer 140, the light emitting element layer 130, the thin-film transistor layer 120 and their interfaces, thereby limiting and/or preventing a decrease in the visibility of an image due to the reflection of the external light.

In the display device 10 according to the current embodiment, since the light control layer LCL is internalized in the encapsulation substrate 200, a visual distortion phenomenon can be limited and/or minimized compared with when a light control film is attached on the polarizing layer POL. For example, since the light control layer LCL is disposed below the polarizing layer POL, a distance between the light control layer LCL and the light emitting element layer 130 in the third direction DR3 may be reduced, thereby limiting or minimizing a double image phenomenon. In addition, since the polarizing layer POL is disposed above the light control layer LCL, a milky haze phenomenon due to the reflection of external light can be limited and/or minimized.

Although not illustrated in the drawing, the display device 10 may further include a cover window. The cover window may be additionally disposed on the polarizing layer POL. In this case, the polarizing layer POL and the cover window may be attached by a transparent adhesive member such as an optically clear adhesive (OCA) film.

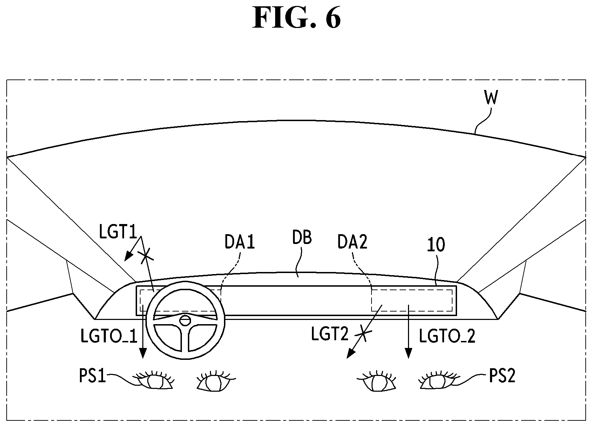

FIG. 6 is a diagram of a case where a display device 10 according to an embodiment is applied to a vehicle.

Referring to FIG. 6 in addition to FIG. 5, the display device 10 according to the embodiment may be, for example, a display device that is applied to an automobile. The automobile may include a body that forms the exterior of the automobile and an interior space defined by the body. The body may include a windshield W that protects a driver PS1 and a passenger PS2 from the outside and provides a view to the driver PS1. The display device 10 may be provided in the interior space as illustrated in the drawing.

In some embodiments, the display device 10 may be disposed on a dashboard DB provided in the interior space. For example, as illustrated in FIG. 6, the display device 10 may extend from a dashboard DB located in front of a driver's seat to a dashboard DB located in front of a passenger seat. For example, the display device 10 may be an integrated display connected (or extending continuously) from the dashboard DB located in front of the driver's seat to the dashboard DB located in front of the passenger seat.

In this case, the display device 10 may include a first display area DA1 located in front of the driver's seat and a second display area DA2 located in front of the passenger seat. The first display area DA1 may be disposed on the dashboard DB in front of the driver's seat to provide speed information, etc. to the driver PS1, and the second display area DA2 may be disposed on the dashboard DB in front of the passenger seat to provide entertainment information, etc. to the passenger PS2. Although not illustrated in the drawing, a third display area may be further included between the first display area DA1 and the second display area DA2.

For another example, the display device 10 may be disposed on each of the dashboard DB in front of the driver's seat and the dashboard DB in front of the passenger seat. For example, a first display device may be disposed on the dashboard DB in front of the driver's seat, and a second display device may be disposed on the dashboard DB in front of the passenger seat.

The driver PS1 may recognize (or view) a display screen of the display device 10 through light LGT0_1 emitted from the display device 10 in front of the driver's seat toward the driver PS1. However, some (LGT1) of the light emitted from the display device 10 in front of the driver's seat may be reflected by the surrounding windshield W to the driver PS1. In this case, an image reflected in the windshield W may interfere with the driving of the driver PS1. On the other hand, the display device 10 according to a preferred embodiment of the present invention adjusts the viewing angle, especially vertical viewing angle, of the light emitted from the display device 10 with respect to a forward direction (a direction facing the driver PS1 directly), thereby limiting and/or preventing some (LGT1) of the light emitted from the display device 10 in front of the driver's seat from being reflected by the surrounding windshield W to the driver PS1.

The passenger PS2 may recognize (or view) the display screen of the display device 10 through light LGT0_2 emitted from the display device 10 in front of the passenger seat toward the passenger PS2. However, some (LGT2) of the light emitted from the display device 10 in front of the passenger seat may be provided toward the driver PS1. In this case, if the automobile is in operation, the viewing of the driver PS1 may be restricted for reasons such as safety. However, the display device 10 according to a preferred embodiment of the present invention may adjust the viewing angle, especially horizontal viewing angle, of the light emitted from the display device 10 with respect to a forward direction (a direction facing the passenger PS2 directly), thereby limiting and/or preventing some (LGT2) of the light emitted from the display device 10 in front of the passenger seat from being provided to the driver PS1.

In the drawing, the display device 10 in front of the driver's seat adjusts the vertical viewing angle, and the display device 10 in front of the passenger seat adjusts the horizontal viewing angle. However, the present invention is not limited thereto. For example, the display device 10 in front of the driver's seat may also adjust the horizontal viewing angle, and the display device 10 in front of the passenger seat may also adjust the vertical viewing angle. For another example, each of the display device 10 in front of the driver's seat and the display device 10 in front of the passenger seat may adjust both the vertical viewing angle and the horizontal viewing angle.

The viewing angle may be adjusted through the light control layer LCL. The viewing angle may be limited to a desired and/or alternatively predetermined angle range through the light control layer LCL. For example, when a virtual line facing the driver PS1 or the passenger PS2 directly and extending in a direction perpendicular to a display surface of the display device 10 is taken as a normal line, the viewing angle may be an angle within 35 degrees from the normal line. In some embodiments, the angle within 35 degrees from the normal line may be defined as an effective viewing angle, but the present invention is not limited thereto.

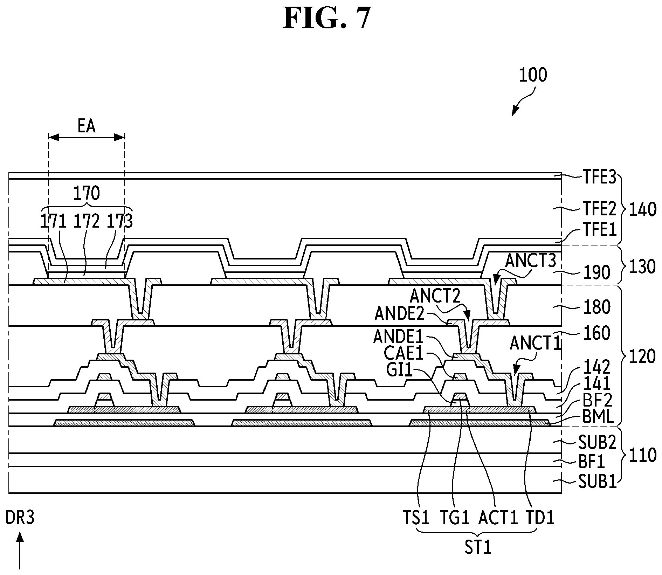

FIG. 7 is a cross-sectional view of an example of a display substrate 100 according to an embodiment.

Referring to FIG. 7, the display substrate 100 may include a base member 110, a thin-film transistor layer 120, a light emitting element layer 130, and a thin-film encapsulation layer 140.

The base member 110 may include a first substrate SUB1, a first buffer layer BF1 disposed on the first substrate SUB1, and a second substrate SUB2 disposed on the first buffer layer BF1.

The first substrate SUB1 and the second substrate SUB2 may be made of an insulating material such as glass, quartz, or polymer resin. The polymer material may be, for example, polyethersulphone (PES), polyacrylate (PA), polyarylate (PAR), polyetherimide (PEI), polyethylene naphthalate (PEN), polyethylene terephthalate (PET), polyphenylene sulfide (PPS), polyallylate, polyimide (PI), polycarbonate (PC), cellulose triacetate (CAT), cellulose acetate propionate (CAP), or a combination thereof. Alternatively, the first substrate SUB1 and the second substrate SUB2 may include a metal material.

The first substrate SUB1 and the second substrate SUB2 may be rigid substrates or flexible substrates that can be bent, folded, or rolled. When the first substrate SUB1 and the second substrate SUB2 are flexible substrates, they may be made of, but not limited to, polyimide (PI).

The first buffer layer BF1 is a layer for protecting first thin-film transistors ST1 and light emitting layers 172 from moisture introduced through the first substrate SUB1 and the second substrate SUB2 which are vulnerable to moisture penetration. The first buffer layer BF1 may be composed of (or include) a plurality of inorganic layers stacked alternately. For example, the first buffer layer BF1 may be a multilayer in which one or more inorganic layers selected from a silicon nitride layer, a silicon oxynitride layer, a silicon oxide layer, a titanium oxide layer, and an aluminum oxide layer are alternately stacked.

The thin-film transistor layer 120 may include bottom metal layers BML, a second buffer layer BF2, the first thin-film transistors ST1, first gate insulating layers GI1, a first interlayer insulating layer 141, first capacitor electrodes CAE1, a second interlayer insulating layer 142, first anode connection electrodes ANDE1, a first organic layer 160, second anode connection electrodes ANDE2, and a second organic layer 180.

The bottom metal layers BML may be disposed on the second substrate SUB2. The bottom metal layers BML may overlap first active layers ACT1 of the first thin-film transistors ST1 in the third direction DR3 to limit and/or prevent leakage current from occurring when light is incident on the first active layers ACT1 of the first thin-film transistors ST1. Each of the bottom metal layers BML may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof. The bottom metal layers BML can be omitted.

The second buffer layer BF2 may be disposed on the bottom metal layers BML. The second buffer layer BF2 is a layer for protecting the first thin-film transistors ST1 and the light emitting layers 172 from moisture introduced through the first substrate SUB1 and the second substrate SUB2 which are vulnerable to moisture penetration. The second buffer layer BF2 may be composed of (or include) a plurality of inorganic layers stacked alternately. For example, the second buffer layer BF2 may be a multilayer in which one or more inorganic layers selected from a silicon nitride layer, a silicon oxynitride layer, a silicon oxide layer, a titanium oxide layer, and an aluminum oxide layer are alternately stacked.

The first active layers ACT1 of the first thin-film transistors ST1 may be disposed on the second buffer layer BF2. The first active layers ACT1 of the first thin-film transistors ST1 include polycrystalline silicon, monocrystalline silicon, low-temperature polycrystalline silicon, amorphous silicon, or an oxide semiconductor. The first active layers ACT1 of the first thin-film transistors ST1 exposed without being covered by the first gate insulating layers GI1 may be doped with impurities or ions to have conductivity. Accordingly, first source electrodes TS1 and first drain electrodes TD1 of the first active layers ACT1 of the first thin-film transistors ST1 may be formed.

The first gate insulating layers GI1 may be disposed on the first active layers ACT1 of the first thin-film transistors ST1. In FIG. 7, the first gate insulating layers GI1 are disposed between first gate electrodes TG1 and the first active layers ACT1 of the first thin-film transistors ST1. However, the present invention is not limited thereto. The first gate insulating layers GI1 may also be disposed between the first interlayer insulating layer 141 and the first active layers ACT1 and between the first interlayer insulating layer 141 and the second buffer layer BF2. Each of the first gate insulating layers GI1 may be made of an inorganic layer, for example, a silicon nitride layer, a silicon oxynitride layer, a silicon oxide layer, a titanium oxide layer, or an aluminum oxide layer.

The first gate electrodes TG1 of the first thin-film transistors ST1 may be disposed on the first gate insulating layers GI1. The first gate electrodes TG1 of the first thin-film transistors ST1 may overlap the first active layers ACT1 in the third direction DR3. Each of the first gate electrodes TG1 of the first thin-film transistors ST1 may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

The first interlayer insulating layer 141 may be disposed on the first gate electrodes TG1 of the first thin-film transistors ST1. The first interlayer insulating layer 141 may be made of an inorganic layer, for example, a silicon nitride layer, a silicon oxynitride layer, a silicon oxide layer, a titanium oxide layer, or an aluminum oxide layer. The first interlayer insulating layer 141 may include a plurality of inorganic layers.

The first capacitor electrodes CAE1 may be disposed on the first interlayer insulating layer 141. The first capacitor electrodes CAE1 may overlap the first gate electrodes TG1 of the first thin-film transistors ST1 in the third direction DR3. Since the first interlayer insulating layer 141 has a desired and/or alternatively predetermined dielectric constant, capacitors may be formed by the first capacitor electrodes CAE1, the first gate electrodes TG1, and the first interlayer insulating layer 141 disposed between them. Each of the first capacitor electrodes CAE1 may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

The second interlayer insulating layer 142 may be disposed on the first capacitor electrodes CAE1. The second interlayer insulating layer 142 may be made of an inorganic layer, for example, a silicon nitride layer, a silicon oxynitride layer, a silicon oxide layer, a titanium oxide layer, or an aluminum oxide layer. The second interlayer insulating layer 142 may include a plurality of inorganic layers.

The first anode connection electrodes ANDE1 may be disposed on the second interlayer insulating layer 142. Each of the first anode connection electrodes ANDE1 may be connected to the first drain electrode TD1 of a first thin-film transistor ST1 through a first anode contact hole ANCT1 penetrating the first interlayer insulating layer 141 and the second interlayer insulating layer 142 to expose the first drain electrode TD1 of the first thin-film transistor ST1. Each of the first anode connection electrodes ANDE1 may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

The first organic layer 160 for planarization may be disposed on the first anode connection electrodes ANDE1. The first organic layer 160 may be made of an organic layer such as acryl resin, epoxy resin, phenolic resin, polyamide resin, or polyimide resin.

The second anode connection electrodes ANDE2 may be disposed on the first organic layer 160. Each of the second anode connection electrodes ANDE2 may be connected to a first anode connection electrode ANDE1 through a second anode contact hole ANCT2 penetrating the first organic layer 160 to expose the first anode connection electrode ANDE1. Each of the second anode connection electrodes ANDE2 may be a single layer or a multilayer made of any one or more of molybdenum (Mo), aluminum (Al), chromium (Cr), gold (Au), titanium (Ti), nickel (Ni), neodymium (Nd), copper (Cu), and alloys thereof.

The second organic layer 180 may be disposed on the second anode connection electrodes ANDE2. The second organic layer 180 may be made of an organic layer such as acryl resin, epoxy resin, phenolic resin, polyamide resin, or polyimide resin.

In FIG. 7, the first thin-film transistors ST1 are formed in a top gate structure in which the first gate electrodes TG1 are located above the first active layers ACT1. However, the present invention is not limited thereto. The first thin-film transistors TFT1 may also be formed in a bottom gate structure in which the first gate electrodes TG1 are located below the first active layers ACT1 or a double gate structure in which the first gate electrodes TG1 are located both above and below the first active layers ACT1.

The light emitting element layer 130 may be disposed on the second organic layer 180. The light emitting element layer 130 may include light emitting elements 170 and a bank 190. Each of the light emitting elements 170 may include a first light emitting electrode 171, a light emitting layer 172, and a second light emitting electrode 173.

The first light emitting electrode 171 may be formed on the second organic layer 180. The first light emitting electrode 171 may be connected to a second anode connection electrode ANDE2 through a third anode contact hole ANCT3 penetrating the second organic layer 180 to expose the second anode connection electrode ANDE2.

In a top emission structure in which light is emitted from the light emitting layer 172 toward the second light emitting electrode 173, the first light emitting electrode 171 may be made of a metal material having high reflectivity, such as a stacked structure (Ti/Al/Ti) of aluminum and titanium, a stacked structure (ITO/Al/ITO) of aluminum and indium tin oxide, an APC alloy, or a stacked structure (ITO/APC/ITO) of an APC alloy and indium tin oxide. The APC alloy is an alloy of silver (Ag), palladium (Pd), and copper (Cu).

The bank 190 may be formed on the second organic layer 180 to separate the first light emitting electrode 171 from another first light emitting electrode 171 so as to define each emission area EA. The bank 190 may include openings, each exposing at least a portion of an upper surface of the first light emitting electrode 171. The bank 190 may be formed to cover edges of the first light emitting electrode 171. The bank 190 may be made of an organic layer such as acryl resin, epoxy resin, phenolic resin, polyamide resin, or polyimide resin.

Each emission area EA is an area in which the first light emitting electrode 171, the light emitting layer 172, and the second light emitting electrode 173 are sequentially stacked so that holes from the first light emitting electrode 171 and electrons from the second light emitting electrode 173 are combined with each other in the light emitting layer 172 to emit light. The emission areas EA may be defined by the openings of the bank 190.

The light emitting layer 172 is formed on the first light emitting electrode 171 and the bank 190. The light emitting layer 172 may be disposed in each opening of the bank 190, but the present invention is not limited thereto. The light emitting layer 172 may include an organic material to emit light of a desired and/or alternatively predetermined color. For example, the light emitting layer 172 may include a hole transporting layer, an organic material layer, and an electron transporting layer.

The second light emitting electrode 173 may be disposed on the light emitting layer 172. The second light emitting electrode 173 may be formed to cover the light emitting layer 172. The second light emitting electrode 173 may be a common layer formed commonly in all emission areas EA. Although not illustrated in the drawing, in some embodiments, a capping layer may be formed on the second light emitting electrode 173.

In the top emission structure, the second light emitting electrode 173 may be made of a transparent conductive material (TCO) that can transmit light, such as indium tin oxide (ITO) or indium zinc oxide (IZO), or a semi-transmissive conductive material such as magnesium (Mg), silver (Ag) or an alloy of Mg and Ag. When the second light emitting electrode 173 is made of a semi-transmissive conductive material, light output efficiency may be increased by a microcavity.

The thin-film encapsulation layer 140 may be disposed on the second light emitting electrode 173. The thin-film encapsulation layer 140 may include at least one inorganic layer to limit and/or prevent oxygen or moisture from permeating into the light emitting element layer 130. In addition, the thin-film encapsulation layer 140 may include at least one organic layer to protect the light emitting element layer 130 from foreign substances such as dust. For example, the thin-film encapsulation layer 140 may include a first encapsulation layer TFE1, a second encapsulation layer TFE2, and a third encapsulation layer TFE3.

The first encapsulation layer TFE1 (e.g., a first inorganic encapsulation layer) may be disposed on the second light emitting electrode 173. The first encapsulation layer TFE1 may be a single-layer or multilayer inorganic layer. The first encapsulation layer TFE1 may be a multilayer or a single layer in which one or more inorganic layers selected from a silicon nitride layer, a silicon oxynitride layer, a silicon oxide layer, a titanium oxide layer, and an aluminum oxide layer are alternately stacked.

The second encapsulation layer TFE2 (e.g., a first organic encapsulation layer) may be disposed on the first encapsulation layer TFE1. The second encapsulation layer TFE2 may be a single-layer or multilayer organic layer. The second encapsulation layer TFE2 may include a polymer-based material. The polymer-based material may include polyethylene terephthalate, polyethylene naphthalate, polycarbonate, polyimide, polyethylene sulfonate, polyoxymethylene, polyarylate, hexamethyldisiloxane, acrylic resin (e.g., polymethyl methacrylate, polyacrylic acid, etc.), or any combination thereof.

The third encapsulation layer TFE3 (e.g., a second inorganic encapsulation layer) may be disposed on the second encapsulation layer TFE2. The third encapsulation layer TFE3 may be a single-layer or multilayer inorganic layer. The third encapsulation layer TFE3 may include the same material as the first encapsulation layer TFE1. For example, the third encapsulation layer TFE3 may be a multilayer or a single layer in which one or more inorganic layers selected from a silicon nitride layer, a silicon oxynitride layer, a silicon oxide layer, a titanium oxide layer, and an aluminum oxide layer are alternately stacked.

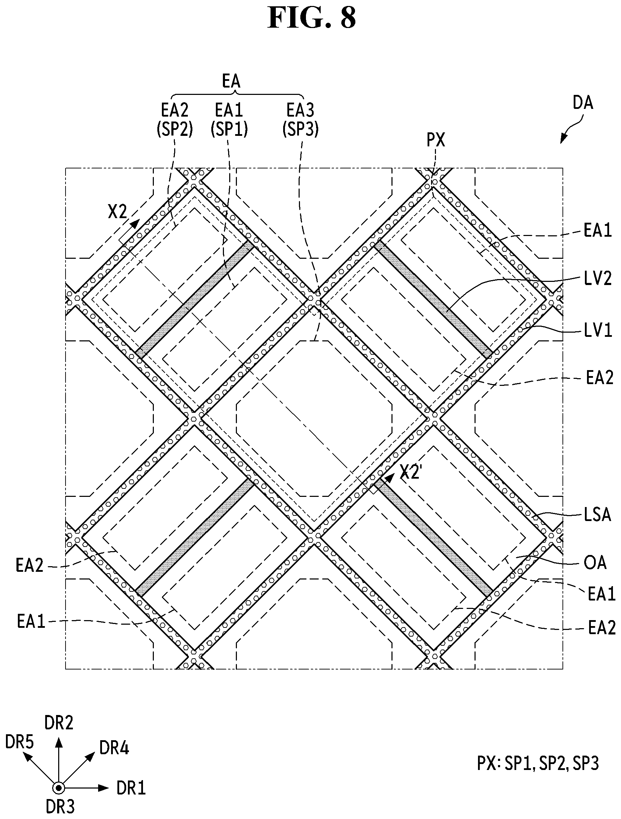

FIG. 8 is a plan view of an example of a portion of a display area DA of a display device 10 according to an embodiment. FIG. 9 is a cross-sectional view taken along line X2-X2' of FIG. 8.

Referring to FIGS. 8 and 9 in addition to FIGS. 5 through 7, each pixel PX may include a plurality of emission areas EA. Each of the emission areas EA may be an area where light generated from a light emitting element 170 is emitted to the outside.

The emission areas EA may be defined by a bank 190. For example, each of the emission areas EA may be an area overlapping a light emitting layer 172 disposed in an opening of the bank 190. Each of the emission areas EA may be an area where a first light emitting electrode 171, the light emitting layer 172, and a second light emitting electrode 173 are sequentially stacked while overlapping each other.

In some embodiments, the emission areas EA may include a first emission area EA1 disposed in a first subpixel SP1, a second emission area EA2 disposed in a second subpixel SP2, and a third emission area EA3 disposed in a third subpixel SP3.

The first emission area EA1 may emit light of a first color, the second emission area EA2 may emit light of a second color, and the third emission area EA3 may emit light of a third color. The light of the first color may be light in a red wavelength band, the light of the second color may be light in a green wavelength band, and the light of the third color may be light in a blue wavelength band. The red wavelength band may be a wavelength band of about 600 to 750 nm, the green wavelength band may be a wavelength band of about 480 to 560 nm, and the blue wavelength band may be a wavelength band of about 370 to 460 nm, but the present invention is not limited thereto.

Each of the first through third emission areas EA1 through EA3 may have a rectangular, square, or rhombic planar shape. For example, as illustrated in the drawings, the first emission area EA1 and the second emission area EA2 may have a rectangular shape, and the third emission area EA3 may have a square shape with chamfered corners. However, the present invention is not limited thereto, and the shape of each of the first through third emission areas EA1 through EA3 can be variously changed to a circular shape, an oval shape, or other polygonal shapes.

As illustrated in the drawings, a pixel PX may include two first emission areas EA1, two second emission areas EA2, and one third emission area EA3. However, the number of emission areas EA included in the pixel PX is not limited thereto and may also be variously changed.

In the pixel PX, one of the two first emission areas EA1 may be disposed on one side of the third emission area EA3 in a fourth direction DR4, and the other may be disposed on one side of the third emission area EA3 in a fifth direction DR5. Similarly, in the pixel PX, one of the two second emission areas EA2 may be disposed on the one side of the third emission area EA3 in the fourth direction DR4, and the other may be disposed on the one side of the third emission area EA3 in the fifth direction DR5.

In the drawings, the fourth direction DR4 may be a diagonal direction between the first direction DR1 and the second direction DR2. For example, the fourth direction DR4 may form an angle of 45 degrees with each of the first direction DR1 and the second direction DR2. The fifth direction DR5 may be a diagonal direction between an opposite direction to the first direction DR1 and the second direction DR2. For example, the fifth direction DR5 may form an angle of 45 degrees with each of the opposite direction to the first direction DR1 and the second direction DR2. The fourth direction DR4 and the fifth direction DR5 may intersect each other in a horizontal direction and may also intersect each of the first direction DR1 and the second direction DR2 in the horizontal direction. For example, the fourth direction DR4 and the fifth direction DR5 may be orthogonal to each other. The fourth direction DR4 and the fifth direction DR5 may intersect the third direction DR3, for example, may be orthogonal to the third direction DR3.

In the pixel PX, the first emission area EA1 and the second emission area EA2 disposed on the one side of the third emission area EA3 in the fourth direction DR4 may include long sides extending in the fifth direction DR5 and short sides extending in the fourth direction DR4. In the pixel PX, the first emission area EA1 and the second emission area EA2 disposed on the one side of the third emission area EA3 in the fifth direction DR5 may include long sides extending in the fourth direction DR4 and short sides extending in the fifth direction DR5.

Among sides of the third emission area EA3 in the pixel PX, a side located on one side in the fourth direction DR4 may face a long side of the second emission area EA2 in the same pixel PX. Among the sides of the third emission area EA3 in the pixel PX, a side located on one side in the fifth direction DR5 may face a long side of the first emission area EA1 in the same pixel PX.

Among the sides of the third emission area EA3 in the pixel PX, a side located on the other side in the fourth direction DR4 may face a short side of each of the first emission area EA1 and the second emission area EA2 in an adjacent pixel PX in an opposite direction to the second direction DR2. Among the sides of the third emission area EA3 in the pixel PX, a side located on the other side in the fifth direction DR5 may face a short side of each of the first emission area EA1 and the second emission area EA2 in an adjacent pixel PX in the opposite direction to the second direction DR2.

The arrangement of the emission areas EA included in the pixel PX is not limited to the illustration in the drawings and can be variously changed.

Sizes or areas of the first through third emission areas EA1 through EA3 may be different from each other. For example, as illustrated in FIG. 8, a size or area of one third emission area EA3 may be larger than a size or area of one second emission area EA2, and the size or area of one second emission area EA2 may be larger than a size or area of one first emission area EA1.

Widths of the first through third emission areas EA1 through EA3 in the fourth direction DR4 may be equal to each other. Widths of the first through third emission areas EA1 through EA3 in the fifth direction DR5 may be different from each other. For example, a width of one third emission area EA3 in the fifth direction DR5 may be greater than a width of one second emission area EA2 in the fifth direction DR5, and the width of one second emission area EA2 in the fifth direction DR5 may be greater than a width of one first emission area EA1 in the fifth direction DR5.

The sizes or areas and widths of the emission areas EA included in the pixel PX are not limited to those illustrated in the drawings and can be variously changed.

The display area DA may include a transmissive area OA and non-transmissive areas LSA. The transmissive area OA may be an area where louvers LV of a light control layer LCL are not disposed in plan view. The non-transmissive areas LSA may be areas where the louvers LV of the light control layer LCL are disposed in plan view.

The non-transmissive areas LSA may be disposed between the emission areas EA. For example, the non-transmissive areas LSA may extend along the fourth direction DR4 and the fifth direction DR5 and may be disposed between the emission areas EA in the fourth direction DR4 and the fifth direction DR5. The emission areas EA may be surrounded by the non-transmissive areas LSA in plan view.

In some embodiments, the non-transmissive areas LSA may not overlap the emission areas EA. Accordingly, the degree to which light emitted from the emission areas EA is obscured by the non-transmissive areas LSA can be limited or minimized, thereby improving the luminance efficiency of the display device 10. In addition, a moire phenomenon that may occur due to interference of light emitted from the emission areas EA by the non-transmissive areas LSA when the emission areas EA and the non-transmissive areas LSA overlap can be limited or minimized.

The transmissive area OA may be the remaining area of the display area DA excluding the non-transmissive areas LSA. The transmissive area OA may be surrounded by the non-transmissive areas LSA. The transmissive area OA may overlap the emission areas EA.

The cross-sectional structure of the display device 10 will now be described with reference to FIG. 9.

The display device 10 may include a display substrate 100, an encapsulation substrate 200, and a polarizing layer POL. Since the display substrate 100 and the polarizing layer POL have been described above, a description thereof will be omitted.

The encapsulation substrate 200 may include the light control layer LCL. The light control layer LCL may include grooves GRV recessed from a surface (e.g., a lower surface in the drawing) of the encapsulation substrate 200 toward the other surface (e.g., an upper surface in the drawing) and louvers LV disposed in the grooves GRV.

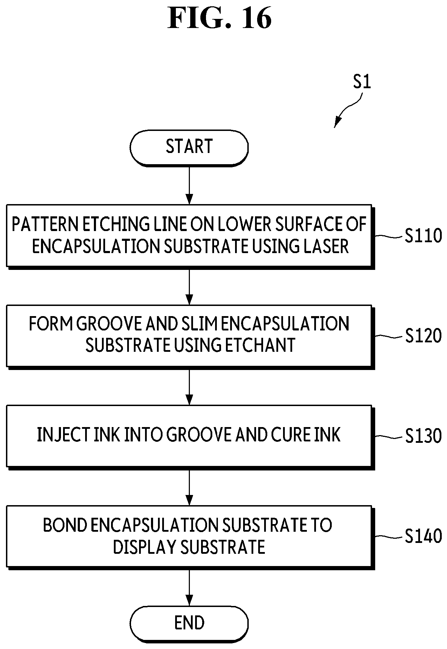

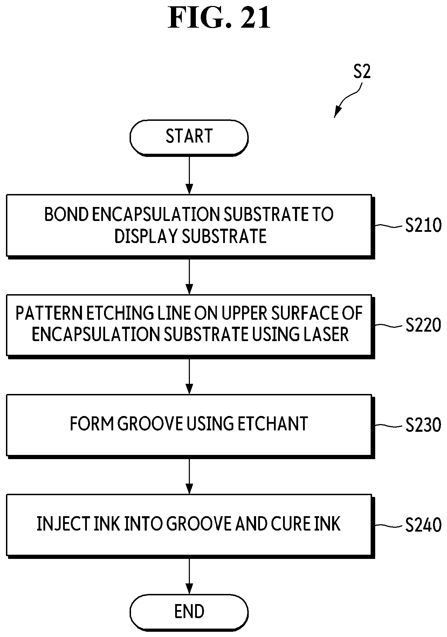

The grooves GRV may be recessed from a surface of the encapsulation substrate 200 (e.g., a surface facing the display substrate 100) toward the other surface (e.g., a surface facing the polarizing layer POL). The grooves GRV may be formed by a laser patterning process and an etching process in methods S1 and S2 of manufacturing a display device which will be described later (see FIGS. 16 and 21).

The grooves GRV may include first grooves GRV1 and second grooves GRV2 having different heights. A height of the first grooves GRV1 may be greater than a height of the second grooves GRV2. For example, the height of the first grooves GRV1 may be a first height H1, and the height of the second grooves GRV2 may be a second height H2. Widths of the first grooves GRV1 and the second grooves GRV2 in the fourth direction DR4 or the fifth direction DR5 may be equal to each other, but the present invention is not limited thereto.

The louvers LV may be disposed in the grooves GRV. The shape of the louvers LV may correspond to the shape of the grooves GRV. The louvers LV may be formed by an ink process in the display device manufacturing methods S1 and S2 which will be described later (see FIGS. 16 and 21).

Each of the louvers LV may have a tapered shape with a wide width at the bottom and a narrow width at the top. However, the present invention is not limited thereto, and each of the louvers LV may also have a pillar shape with the same width at the bottom and top.

The louvers LV may absorb or block light emitted from the first through third emission areas EA1 through EA3. The louvers LV may include a light-blocking organic material. For example, a light blocking layer LS may be a photosensitive resin that can absorb or block light and may include an organic material including an organic black pigment such as carbon black.

In some embodiments, the louvers LV may include first louvers LV1 and second louvers LV2 having different heights. A height of the first louvers LV1 may be greater than a height of the second louvers LV2. For example, the height of the first louvers LV1 may be the first height H1, and the height of the second louvers LV2 may be the second height H2. Widths of the first louvers LV1 and the second louvers LV2 in the fourth direction DR4 or the fifth direction DR5 may be equal to each other, but the present invention is not limited thereto.

The louvers LV may be disposed between the emission areas EA. Although not illustrated in the drawings, the first through third emission areas EA1 through EA3 may be spaced apart from each other by the bank 190. Therefore, the louvers LV may overlap the bank 190 while not overlapping the first through third emission areas EA1 through EA3 and may be disposed on the bank 190.

In some embodiments, as illustrated in FIG. 8, louvers LV surrounding the third emission area EA3 among the louvers LV may be first louvers LV1, and louvers LV disposed between the first and second emission areas EA1 and EA2 in the fourth direction DR4 or the fifth direction DR5 may be second louvers LV2.

For example, as illustrated in FIG. 9, the louvers LV may include a first light blocking louver LV21 disposed between the second emission area EA2 and the first emission area EA1 in the fifth direction DR5, a second light blocking louver LV13 disposed between the first emission area EA1 and the third emission area EA3 in the fifth direction DR5, and a third light blocking louver LV32 disposed between the third emission area EA3 and the second emission area EA2 in the fifth direction DR5.

The second light blocking louver LV13 and the third light blocking louver LV32 may be first louvers LV1 having the first height H1, and the first light blocking louver LV21 may be a second louver LV2 having the second height H2.

As illustrated in FIG. 9, the first light blocking louver LV21 disposed on one side of the first emission area EA1 in the fifth direction DR5 may be a second louver LV2 having a low height, and the second light blocking louver LV13 disposed on the other side of the first emission area EA1 in the fifth direction DR5 may be a first louver LV1 having a high height. The third light blocking louver LV32 disposed on one side of the second emission area EA2 in the fifth direction DR5 may be a first louver LV1 having a high height, and the first light blocking louver LV21 disposed on the other side of the second emission area EA2 in the fifth direction DR5 may be a second louver LV2 having a low height. The second light blocking louver LV13 disposed on one side of the third emission area EA3 in the fifth direction DR5 may be a first louver LV1 having a high height, and the third light blocking louver LV32 disposed on the other side of the third emission area EA3 in the fifth direction DR5 may be a first louver LV1 having a high height.

Since the heights of the louvers LV disposed on one side and the other side of each of the first emission area EA1 and the second emission area EA2 are different, distances from the louvers LV on the one side and the other side may also be different. Since the heights of the louvers LV disposed on one side and the other side of the third emission area EA3 are the same, distances from the louvers LV on the one side and the other side may also be the same.

For example, a distance D1R between the first emission area EA1 and the first light blocking louver LV21 in the fifth direction DR5 may be smaller than a distance D2R between the first emission area EA1 and the second light blocking louver LV13 in the fifth direction DR5. A distance D2G between the second emission area EA2 and the first light blocking louver LV21 in the fifth direction DR5 may be smaller than a distance D1G between the second emission area EA2 and the third light blocking louver LV32 in the fifth direction DR5. A distance D1B between the third emission area EA3 and the second light blocking louver LV13 in the fifth direction DR5 may be equal to a distance D2B between the third emission area EA3 and the third light blocking louver LV32 in the fifth direction DR5.

In some embodiments, since a width WR of the first emission area EA1 in the fifth direction DR5 is smaller than a width WG of the second emission area EA2 in the fifth direction DR5, the distance D1R between the first emission area EA1 and the first light blocking louver LV21 in the fifth direction DR5 may be greater than the distance D2G between the second emission area EA2 and the first light blocking louver LV21 in the fifth direction DR5, and the distance D2R between the first emission area EA1 and the second light blocking louver LV13 in the fifth direction DR5 may be greater than the distance D1G between the second emission area EA2 and the third light blocking louver LV32 in the fifth direction DR5. Since the width WR of the first emission area EA1 in the fifth direction DR5 and the width WG of the second emission area EA2 in the fifth direction DR5 are smaller than a width WB of the third emission area EA3 in the fifth direction DR5, the distance D2R between the first emission area EA1 and the second light blocking louver LV13 in the fifth direction DR5 and the distance D1G between the second emission area EA2 and the third light blocking louver LV32 in the fifth direction DR5 may be greater than the distance D1B between the third emission area EA3 and the second light blocking louver LV13 in the fifth direction DR5 and the distance D2B between the third emission area EA3 and the third light blocking louver LV32 in the fifth direction DR5.

In some embodiments, widths of the first light blocking louver LV21, the second light blocking louver LV13, and the third light blocking louver LV32 in the fourth direction DR4 or the fifth direction DR5 may be equal to each other. For example, a width W21 of the first light blocking louver LV21, a width W13 of the second light blocking louver LV13, and a width W32 of the third light blocking louver LV32 may be equal to each other. However, the present invention is not limited thereto, and the widths of the louvers LV may also be different from each other.

In the display device 10 according to the current embodiment, the louvers LV surrounding the third emission area EA3 having a relatively large size or area are first louvers LV having a high height, and the louvers LV adjacent to the first emission area EA1 and the second emission area EA2 having a relatively small size or area are second louvers LV2 having a low height. Therefore, viewing angles of light emitted from the first through third emission areas EA1 through EA3 can be equally controlled. That is, the louvers LV adjacent to the third emission area EA3 may be formed high to adjust a light output rate of light emitted from the third emission area EA3 to the same level as a light output rate of light emitted from the first and second emission areas EA1 and EA2, thereby equally controlling the viewing angles of the light emitted from the first through third emission areas EA1 through EA3.

In addition, since a second louver LV2 having a low height is disposed on one side of the first emission area EA1, but a first louver LV1 having a high height is disposed on the other side, a distance between the first emission area EA1 and the second louver LV2 may be made smaller than a distance between the first emission area EA1 and the first louver LV1 to equally control the viewing angles of light emitted to the one side and the other side of the first emission area EA1.

Similarly, since a second louver LV2 having a low height is disposed on the other side of the second emission area EA2, but a first louver LV1 having a high height is disposed on one side, a distance between the second emission area EA2 and the second louver LV2 may be made smaller than a distance between the second emission area EA2 and the first louver LV1 to equally control the viewing angles of light emitted to the one side and the other side of the second emission area EA2.

As described above, the viewing angles of light emitted from the first through third emission areas EA1 through EA3 are equally controlled through the first and second louvers LV1 and LV2 having different heights. In addition, the viewing angles of light emitted to one side and the other side of the first and second emission areas EA1 and EA2 are equally controlled by differentiating the distances between the first and second emission areas EA1 and EA2 and the first and second louvers LV1 and LV2. Therefore, visual distortion phenomena such as moire and milky haze can be limited and/or minimized.

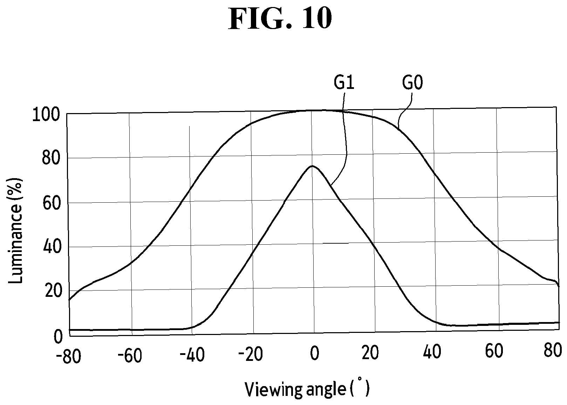

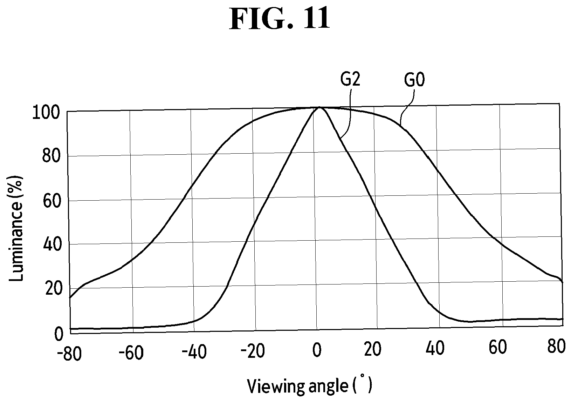

FIG. 10 is a graph illustrating luminance with respect to the viewing angle of a display device according to a comparative example. FIG. 11 is a graph illustrating luminance with respect to the viewing angle of a display device 10 according to an embodiment.

Referring to FIGS. 10 and 11 in addition to FIGS. 5, 8 and 9, a reference graph G0 is a graph showing luminance with respect to the viewing angle of a display device that does not include a light control layer LCL. A first graph G1 of FIG. 10 is a graph showing luminance with respect to the viewing angle of the display device according to the comparative example. A second graph G2 of FIG. 11 is a graph showing luminance with respect to the viewing angle of the display device 10 according to the embodiment.

The display device according to the comparative example is different from the display device 10 according to the embodiment in that the light control layer LCL is not included in the encapsulation substrate 200 (see the display device 10 illustrated in FIG. 5) and that a light control film manufactured separately is attached and placed on the polarizing layer POL.

The light control film manufactured separately and attached to the display device according to the comparative example includes louvers shaped like straight lines extending only in the first direction DR1 or the second direction DR2 regardless of the shape and arrangement of emission areas EA. In addition, the light control film is generally manufactured through a mold roll, in which case the louvers are formed to have a uniform height.

Therefore, as shown in the first graph G1 of FIG. 10, the display device according to the comparative example exhibits lower luminance than the reference graph G0 at a front viewing angle (a 0-degree position on the x axis of the graph) because the light control film overlaps the emission areas EA.

On the other hand, in the display device 10 according to the current embodiment, louvers LV may be formed in a shape and arrangement corresponding to the shape and arrangement of emission areas EA by using a laser patterning process, as in the display device manufacturing methods S1 and S2 which will be described later (see FIGS. 16 and 21).

Therefore, as shown in the second graph G2 of FIG. 11, the display device 10 according to the embodiment may have a luminance level equivalent to that of the reference graph G0 at the front viewing angle (the 0-degree position on the x axis of the graph). In addition, since the shape and arrangement of the louvers LV correspond to the shape and arrangement of the emission areas EA, a moire phenomenon can be limited and/or minimized.

In the display device according to the comparative example, since a light control film is manufactured separately and attached onto the polarizing layer POL, a distance between the light control film and a light emitting layer is large, causing double images and milky haze. On the other hand, in the display device 10 according to the current embodiment, since the light control layer LCL is disposed on the lower surface of the encapsulation substrate 200, a distance between the light control layer LCL and the light emitting layer is small, and double images and milky haze may be limited and/or minimized.

Hereinafter, other embodiments of the display device 10 according to the embodiment will be described. In the following embodiments, the same elements as those of the above-described embodiment will be indicated by the same reference numerals, and their redundant description will be omitted or given briefly, and differences will be mainly described.

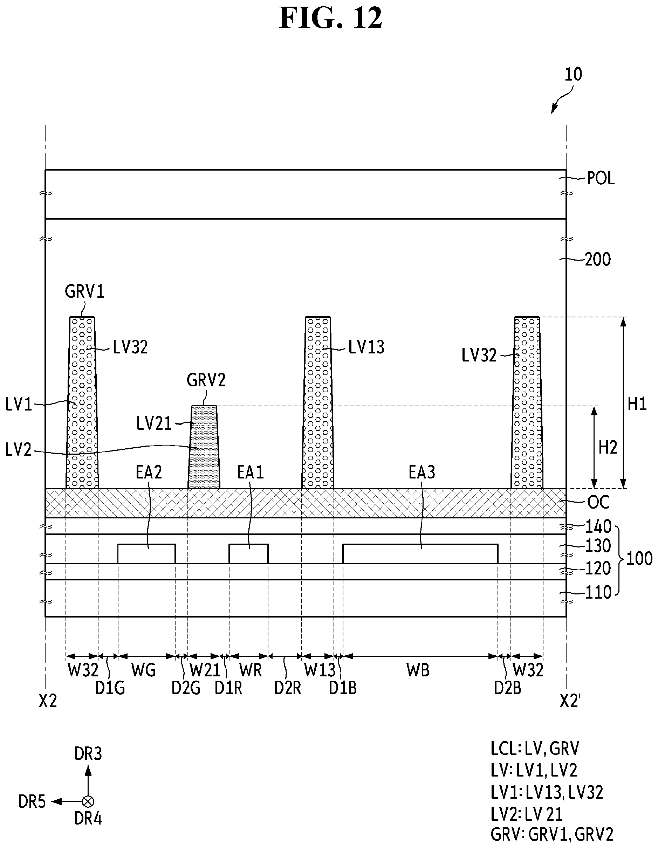

FIG. 12 is a cross-sectional view of a display device 10 according to an embodiment.

Referring to FIG. 12, the display device 10 according to the current embodiment is different from the display device 10 according to the embodiment described with reference to FIG. 9, etc. in that it further includes an overcoat layer OC.

For example, an encapsulation substrate 200 of the display device 10 may further include the overcoat layer OC. The overcoat layer OC may be disposed on a lower surface of the encapsulation substrate 200. The overcoat layer OC may cover lower surfaces of louvers LV and the lower surface of the encapsulation substrate 200.

Since the display device 10 according to the current embodiment includes the overcoat layer OC, the durability of the encapsulation substrate 200 and the display device 10 can be improved. A light control layer LCL of the encapsulation substrate 200 may be formed by a laser patterning process, an etching process, and an ink process according to the display device manufacturing methods S1 and S2 which will be described later (see FIGS. 16 and 21). During these manufacturing processes, the lower surfaces of the louvers LV and the lower surface of the encapsulation substrate 200 may crack or weaken in strength. Therefore, the overcoat layer OC may be disposed to cover the lower surfaces of the louvers LV and the lower surface of the encapsulation substrate 200, thereby improving the durability of the encapsulation substrate 200 and the display device 10.

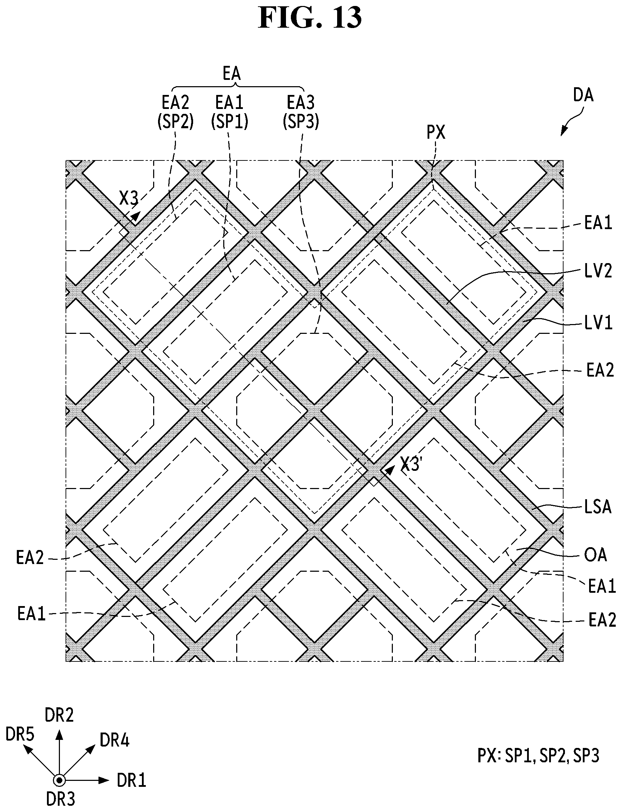

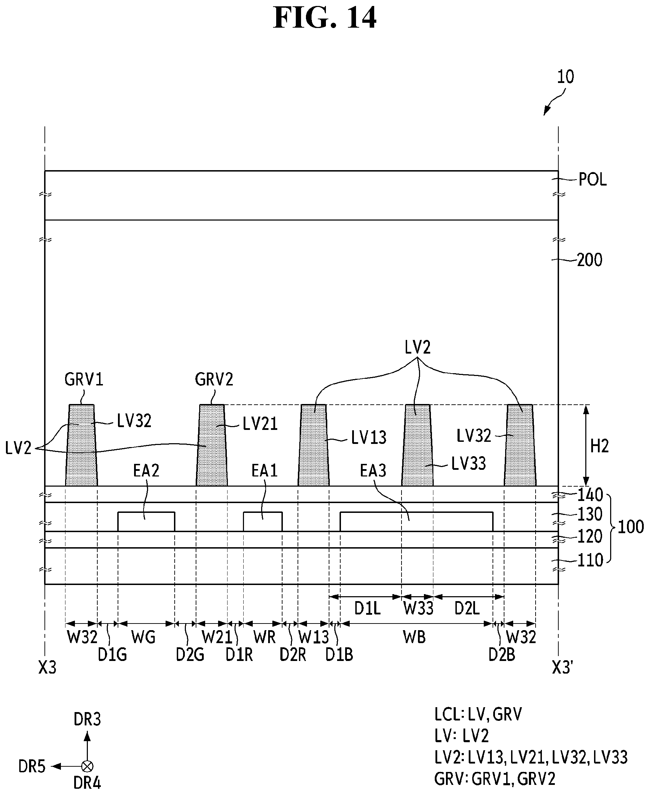

FIG. 13 is a plan view of an example of a portion of a display area DA of a display device 10 according to an embodiment. FIG. 14 is a cross-sectional view taken along line X3-X3' of FIG. 13.

Referring to FIGS. 13 and 14, the display device 10 according to the current embodiment is different from the display device 10 according to the embodiment described with reference to FIG. 9, etc. in that it further includes a fourth light blocking louver LV33 and that louvers LV are composed of (or include) second louvers LV2 having the same height.

For example, non-transmissive areas LSA may be disposed between emission areas EA and may overlap at least a portion of a third emission area EA3. For example, the non-transmissive areas LSA may extend along the fourth direction DR4 and the fifth direction DR5, may be disposed between the emission areas EA in the fourth direction DR4 and the fifth direction DR5, and may overlap the third emission area EA3 in plan view.

In the drawings, the non-transmissive areas LSA overlapping the third emission area EA3 are disposed in an 'X' shape on the third emission area EA3. However, the present invention is not limited thereto. For example, the non-transmissive areas LSA overlapping the third emission area EA3 may extend only in the fourth direction DR4 or only in the fifth direction DR5.

A transmissive area OA may be the remaining area of the display area DA excluding the non-transmissive areas LSA. The transmissive area OA may be surrounded by the non-transmissive areas LSA. The transmissive area OA may overlap the emission areas EA.

In the current embodiment, as illustrated in FIG. 14, the louvers LV may be composed of (or include) the second louvers LV2 having the same height. For example, the louvers LV may be composed of (or include) the second louvers LV2 having a second height H2.

In the current embodiment, as illustrated in FIG. 13, not only louvers LV disposed between the emission areas EA but also louvers LV overlapping the third emission areas EA3 may be the second louvers LV2.

For example, like the louvers LV of the display device 10 according to the embodiment described with reference to FIG. 9, the louvers LV may include a first light blocking louver LV21 disposed between a second emission area EA2 and a first emission area EA1 in the fifth direction DR5, a second light blocking louver LV13 disposed between the first emission area EA1 and the third emission area EA3 in the fifth direction DR5, and a third light blocking louver LV32 disposed between the third emission area EA3 and the second emission area EA2 in the fifth direction DR5 as illustrated in FIG. 14.

In the current embodiment, heights of the first through third light blocking louvers LV21, LV13 and LV32 may all be the same second height H2. That is, the first through third light blocking louvers LV21, LV13 and LV32 may each be configured as a second louver LV2.

Unlike the louvers LV of the display device 10 according to the embodiment described with reference to FIG. 9, etc., the louvers LV of the display device 10 according to the current embodiment may further include the fourth light blocking louver LV33.

The fourth light blocking louver LV33 may overlap the third emission area EA3 in the third direction DR3. The fourth light blocking louver LV33 may be disposed between the second light blocking louver LV13 and the third light blocking louver LV32 in the fifth direction DR5. Like the first through third light blocking louvers LV21, LV13 and LV32, the fourth light blocking louver LV33 may have the second height H2 and may be configured as a second louver LV2.

In the current embodiment, since all of the louvers LV disposed on one side and the other side of each of the first through third emission areas EA1 through EA3 have the same height, distances from the louvers LV on the one side and the other side may also be the same.

For example, a distance D1R between the first emission area EA1 and the first light blocking louver LV21 in the fifth direction DR5 may be equal to a distance D2R between the first emission area EA1 and the second light blocking louver LV13 in the fifth direction DR5. A distance D2G between the second emission area EA2 and the first light blocking louver LV21 in the fifth direction DR5 may be equal to a distance D1G between the second emission area EA2 and the third light blocking louver LV32 in the fifth direction DR5. A distance D1B between the third emission area EA3 and the second light blocking louver LV13 in the fifth direction DR5 may be equal to a distance D2B between the third emission area EA3 and the third light blocking louver LV32 in the fifth direction DR5.

In some embodiments, a distance D1L between the second light blocking louver LV13 and the fourth light blocking louver LV33 in the fifth direction DR5 may be equal to a distance D2L between the fourth light blocking louver LV33 and the third light blocking louver LV32 in the fifth direction DR5.

However, the present invention is not limited thereto, and the distance D1L between the second light blocking louver LV13 and the fourth light blocking louver LV33 in the fifth direction DR5 may also be different from the distance D2L between the fourth light blocking louver LV33 and the third light blocking louver LV32 in the fifth direction DR5. In this case, the distance D1B between the third emission area EA3 and the second light blocking louver LV13 in the fifth direction DR5 may be different from the distance D2B between the third emission area EA3 and the third light blocking louver LV32 in the fifth direction DR5. For example, when the distance D1L between the second light blocking louver LV13 and the fourth light blocking louver LV33 in the fifth direction DR5 is smaller than the distance D2L between the fourth light blocking louver LV33 and the third light blocking louver LV32 in the fifth direction DR5, the distance D1B between the third emission area EA3 and the second light blocking louver LV13 in the fifth direction DR5 may be greater than the distance D2B between the third emission area EA3 and the third light blocking louver LV32 in the fifth direction DR5. For another example, when the distance D1L between the second light blocking louver LV13 and the fourth light blocking louver LV33 in the fifth direction DR5 is greater than the distance D2L between the fourth light blocking louver LV33 and the third light blocking louver LV32 in the fifth direction DR5, the distance D1B between the third emission area EA3 and the second light blocking louver LV13 in the fifth direction DR5 may be smaller than the distance D2B between the third emission area EA3 and the third light blocking louver LV32 in the fifth direction DR5.

In some embodiments, a width of the fourth light blocking louver LV33 in the fourth direction DR4 or the fifth direction DR5 may be equal to widths of the first light blocking louver LV21, the second light blocking louver LV13, and the third light blocking louver LV32 in the fourth direction DR4 or the fifth direction DR5. For example, a width W33 of the fourth light blocking louver LV33 may be equal to a width W21 of the first light blocking louver LV21, a width W13 of the second light blocking louver LV13, and a width W32 of the third light blocking louver LV32. However, the present invention is not limited thereto, and the widths of the louvers LV may also be different from each other.

In the display device 10 according to the current embodiment, louvers LV surrounding the third emission area EA3 having a relatively large size or area and the first and second emission areas EA1 and EA2 having a relatively small size or area are formed to have the same height, but a louver LV (e.g., the fourth light blocking louver LV33) overlapping the third emission area EA3 is further placed. Therefore, viewing angles of light emitted from the first through third emission areas EA1 through EA3 can be equally controlled. That is, a louver LV overlapping the third emission area EA3 is further disposed to adjust a light output rate of light emitted from the third emission area EA3 to the same level as a light output rate of light emitted from the first and second emission areas EA1 and EA2, thereby equally controlling the viewing angles of the light emitted from the first through third emission areas EA1 through EA3.

In the display device 10 according to the current embodiment, since all of the louvers LV disposed on one side and the other side of each of the first through third emission areas EA1 through EA3 have the same height, distances from the louvers LV on the one side and the other side may also be the same. Therefore, the viewing angles of light emitted to the one side and the other side of each of the first through third emission areas EA1 through EA3 can be equally controlled.

In the display device 10 according to the current embodiment, when the distance D1L between the second light blocking louver LV13 and the fourth light blocking louver LV33 in the fifth direction DR5 is different from the distance D2L between the fourth light blocking louver LV33 and the third light blocking louver LV32 in the fifth direction DR5, the distance D1B between the third emission area EA3 and the second light blocking louver LV13 in the fifth direction DR5 may be made different from the distance D2B between the third emission area EA3 and the third light blocking louver LV32 in the fifth direction DR5. Therefore, the viewing angles of light emitted to one side and the other side of the third emission area EA3 can be equally controlled.

By equally controlling the viewing angles of light emitted from the emission areas EA as described above, it is possible to limit and/or minimize visual distortion phenomena such as moire and milky haze.

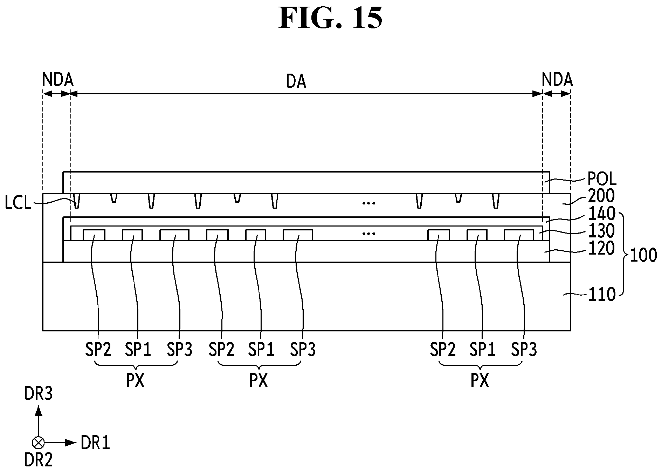

FIG. 15 is a cross-sectional view of a display device 10 according to an embodiment.

Referring to FIG. 15, the display device 10 according to the current embodiment is different from the display device 10 according to the embodiment described with reference to FIG. 5, etc. in that a light control layer LCL is disposed adjacent to an upper surface of an encapsulation substrate 200.

For example, the encapsulation substrate 200 may include the light control layer LCL. The encapsulation substrate 200 may include grooves GRV recessed in a direction from a surface of the encapsulation substrate 200 toward the other surface, for example, in a thickness direction (or the third direction DR3) and louvers LV disposed in the grooves GRV. The grooves GRV and the louvers LV may be included in the light control layer LCL.

For example, the grooves GRV may be recessed from a surface (e.g., the upper surface in the drawing) of the encapsulation substrate 200 toward the other surface (e.g., a lower surface in the drawing). The grooves GRV may be recessed from a surface facing the polarizing layer POL toward a surface facing a display substrate 100.

The louvers LV may be disposed in the grooves GRV and may extend from the upper surface of the encapsulation substrate 200 toward the lower surface. The louvers LV may be disposed adjacent to the upper surface of the encapsulation substrate 200. Each of the louvers LV may have a reverse-tapered shape with a wide width at the top and a narrow width at the bottom. However, the present invention is not limited thereto, and each of the louvers LV may also have a pillar shape with the same width at the bottom and top.

The structure in which the light control layer LCL is disposed adjacent to the upper surface of the encapsulation substrate 200 as in the current embodiment can be applied not only to the display device 10 according to the embodiment described with reference to FIG. 5, etc., but also to the display device 10 according to the embodiment described with reference to FIG. 12 and to the display device 10 according to the embodiment described with reference to FIGS. 13 and 14.

The structure in which the light control layer LCL is disposed adjacent to the lower surface of the encapsulation substrate 200, as in the display device 10 according to the embodiment described with reference to FIG. 5, etc., may be manufactured by a method S1 of manufacturing a display device according to an embodiment which will be described later (see FIG. 16). On the other hand, the structure in which the light control layer LCL is disposed adjacent to the upper surface of the encapsulation substrate 200, as in the display device 10 according to the current embodiment described with reference to FIG. 15, may be manufactured by a method S2 (see FIG. 21) of manufacturing a display device according to an embodiment which will be described later.

Methods of manufacturing a display device according to embodiments will now be described.

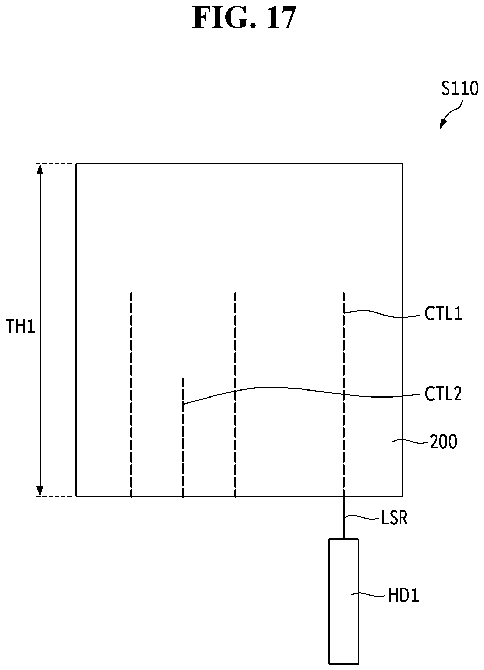

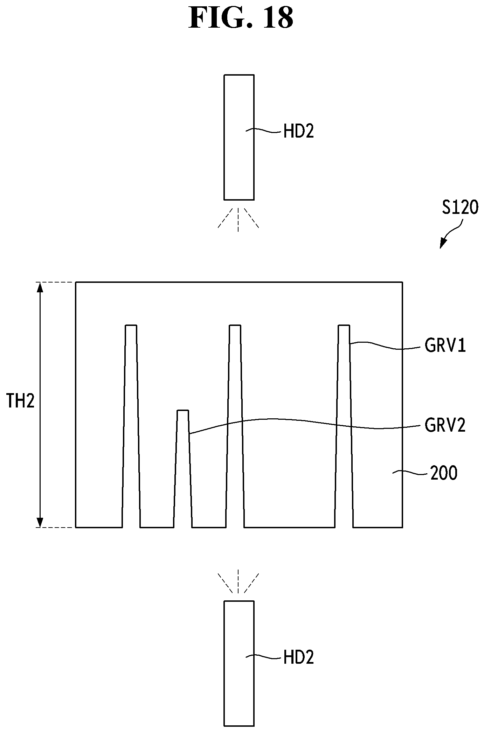

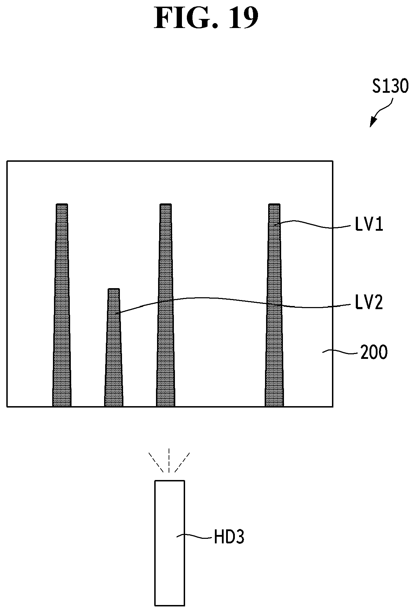

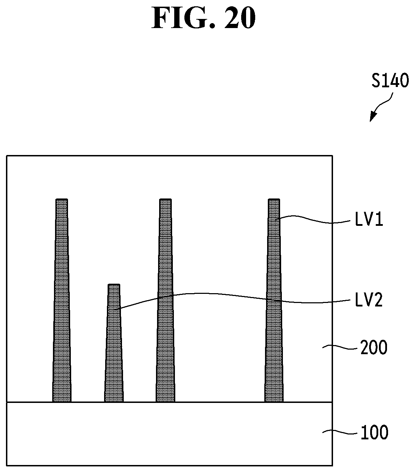

FIG. 16 is a flowchart illustrating a method S1 of manufacturing a display device according to an embodiment. FIG. 17 is a cross-sectional view illustrating operation S110 of FIG. 16. FIG. 18 is a cross-sectional view illustrating operation S120 of FIG. 16. FIG. 19 is a cross-sectional view illustrating operation S130 of FIG. 16. FIG. 20 is a cross-sectional view illustrating operation S140 of FIG. 16.

Referring to FIGS. 16 through 20, the method S1 of manufacturing the display device according to the embodiment may include patterning an etching line on a lower surface of an encapsulation substrate using a laser (operation S110), forming a groove and slimming the encapsulation substrate using an etchant (operation S120), injecting ink into the groove and curing the ink (operation S130), and bonding the encapsulation substrate to a display substrate (operation S140).

First, as illustrated in FIG. 17, in the patterning of the etching line on the lower surface of the encapsulation substrate using the laser (operation S110), a first head HD1 may irradiate a laser LSR to a lower surface of an encapsulation substrate 200.

The first head HD1 may be a laser generating device. For example, the first head HD1 may be a glass processing device using the laser LSR and/or other apparatus including a laser. The laser LSR generated from the first head HD1 may be, but is not limited to, light in an infrared wavelength range.

The first head HD1 may form cutting lines CTL1 and CTL2 by inducing a phase change of a material included in the encapsulation substrate 200 through the laser LSR. For example, when the encapsulation substrate 200 includes glass, the molecular arrangement of silicon dioxide included in the glass may be changed to weaken their bonding strength. Accordingly, regions whose bonding strength between molecules is different from that of a region to which the laser LSR is not irradiated may be formed, and such regions may be the cutting lines CTL1 and CTL2.

The cutting lines CTL1 and CTL2 may include first cutting lines CTL1 and second cutting lines CTL2. The second cutting lines CTL2 may have a lower depth than the first cutting lines CTL1. The first head HD1 may form the second cutting lines CTL2 having a lower depth than the first cutting lines CTL1 by lowering the intensity of the laser LSR.

Next, as illustrated in FIG. 18, in the forming of the groove and the slimming of the encapsulation substrate using the etchant (operation S120), a second head HD2 may spray an etchant onto the lower surface of the encapsulation substrate 200. At this time, the encapsulation substrate 200 may be etched along the cutting lines CTL1 and CTL2 which are regions with weakened bonding strength. Accordingly, grooves GRV1 and GRV2 may be formed along the cutting lines CTL1 and CTL2.

The grooves GRV1 and GRV2 may include first grooves GRV1 and second grooves GRV2. The second grooves GRV2 may have a lower depth than the first grooves GRV1.

The second head HD2 may spray an etchant onto an upper surface of the encapsulation substrate 200. At this time, the encapsulation substrate 200 having a first thickness TH1 may be slimmed to a second thickness TH2.

In some embodiments, the etchant used to form the grooves GRV1 and GRV2 and the etchant used for slimming may include different components, but the present invention is not limited thereto.

In the drawing, the second head HD2 sprays an etchant onto the lower or upper surface of the encapsulation substrate 200. However, the present invention is not limited thereto. For example, when the etching process is performed as wet etching, the second head HD2 may directly put or immerse the encapsulation substrate 200 in an etchant instead of spraying the etchant. The second head HD2 may include a nozzle, in fluid communication with a container storing an etchant, and a pump for providing the etchant.

Next, as illustrated in FIG. 19, in the injecting of the ink into the groove and the curing of the ink (operation S130), a third head HD3 may inject ink containing a light blocking material into the grooves GRV1 and GRV2. For example, the ink may be a photosensitive resin that can absorb or block light and may include a light-blocking organic material including an organic black pigment such as carbon black.

The third head HD3 may cure the ink injected into the grooves GRV1 and GRV2 using light such as ultraviolet light or heat. Alternatively, the ink may be naturally cured. The third head HD3 may include a nozzle and/or pump for injecting ink and may include a UV diode or lamp for curing.

The ink may be cured to form first louvers LV1 in the first grooves GRV1 and second louvers LV2 in the second grooves GRV2.

Although not illustrated in the drawing, if the ink overflows the grooves GRV1 and GRV2 and is cured, a polishing process may be further included to remove the overflowed, cured ink outside the grooves GRV1 and GRV2. For example, the polishing process may be a chemical mechanical polishing process.

Next, as illustrated in FIG. 20, in the bonding of the encapsulation substrate to the display substrate (operation S140), the encapsulation substrate 200 including the louvers LV1 and LV2 may be bonded to a display substrate 100 prepared in advance.

In the method S1 of manufacturing the display device according to the current embodiment, since the cutting lines CTL1 and CTL2 are patterned in advance using the laser LSR, the alignment accuracy of the louvers LV1 and LV2 can be improved. Accordingly, the yield problem due to an alignment error can be improved compared with when a separate light control film is attached to the encapsulation substrate 200.

In addition, since patterning using the laser LSR enables precise patterning according to the shape and arrangement of emission areas, louvers can be patterned in various shapes and arrangements.

In addition, since the etching process for forming the grooves GRV1 and GRV2 and the process for slimming the encapsulation substrate 200 can be performed successively or simultaneously, process efficiency can be improved.

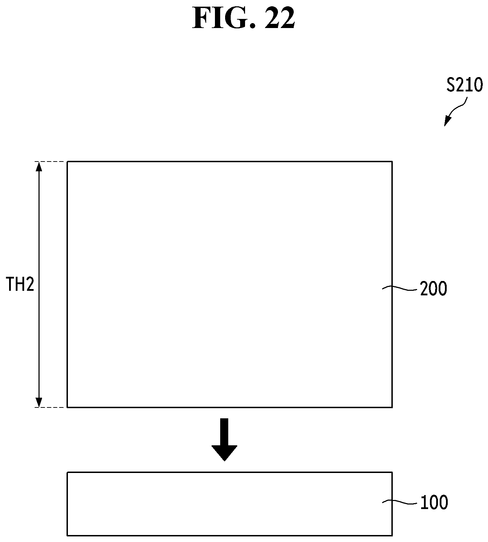

FIG. 21 is a flowchart illustrating a method of manufacturing a display device according to an embodiment. FIG. 22 is a cross-sectional view illustrating operation S210 of FIG. 21.

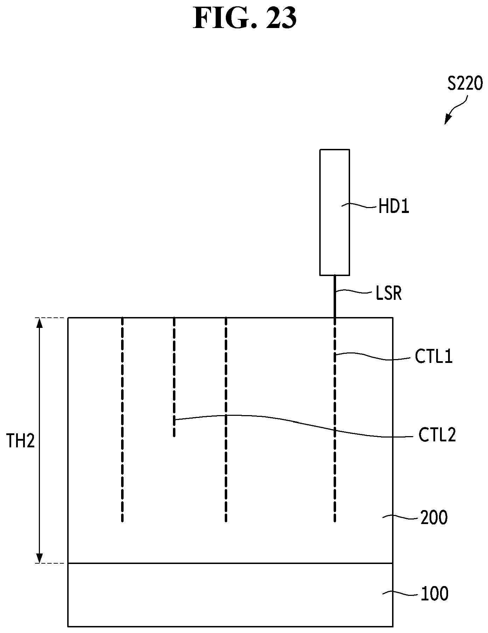

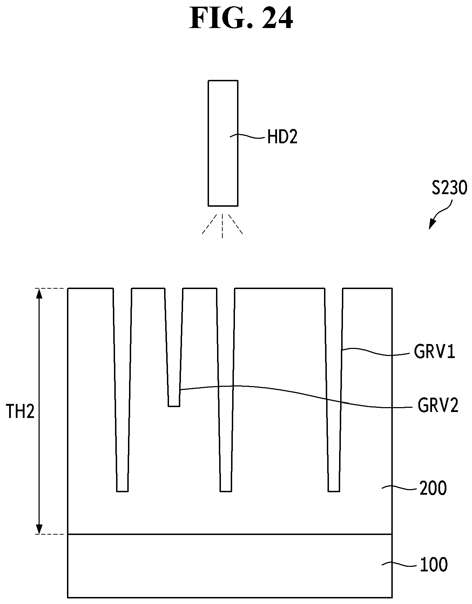

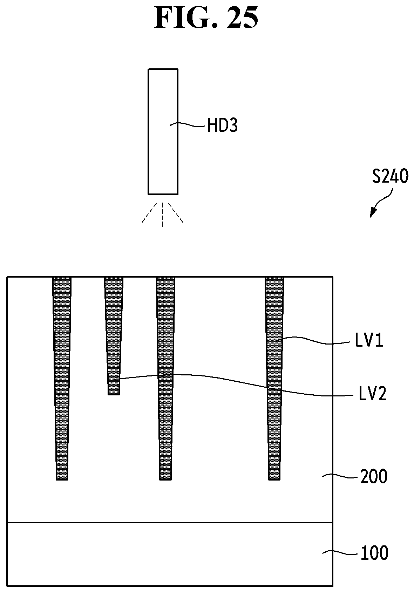

FIG. 23 is a cross-sectional view illustrating operation S220 of FIG. 21. FIG. 24 is a cross-sectional view illustrating operation S230 of FIG. 21. FIG. 25 is a cross-sectional view illustrating operation S240 of FIG. 21.

Referring to FIGS. 21 through 25, the method S2 of manufacturing the display device according to the current embodiment is different from the method S1 of manufacturing the display device according to the embodiment described with reference to FIG. 16, etc. in that a laser patterning process, an etching process and an ink process are performed after an encapsulation substrate 200 and a display substrate 100 are bonded together, and louvers LV1 and LV2 are formed on an upper surface of the encapsulation substrate 200.

For example, the method S2 of manufacturing the display device according to the current embodiment may include bonding an encapsulation substrate to a display substrate (operation S210), patterning an etching line on an upper surface of the encapsulation substrate using a laser (operation S220), forming a groove using an etchant (operation S230), and injecting ink into the groove and curing the ink (operation S240).

First, as illustrated in FIG. 22, the bonding of the encapsulation substrate to the display substrate (operation S210) may be performed before the patterning of the etching line on the upper surface of the encapsulation substrate using the laser (operation S220), the forming of the groove using the etchant (operation S230), and the injecting of the ink into the groove and the curing of the ink (operation S240). In this case, since a lower surface of the encapsulation substrate 200 is covered by the display substrate 100, the louvers LV1 and LV2 may be formed on the upper surface of the encapsulation substrate 200.

Next, as illustrated in FIG. 23, in the patterning of the etching line on the upper surface of the encapsulation substrate using the laser (operation S220), a first head HD1 may irradiate a laser LSR to the upper surface of the encapsulation substrate 200. Accordingly, cutting lines CTL1 and CTL2 may be formed in a direction from the upper surface of the encapsulation substrate 200 toward the lower surface.

Next, as illustrated in FIG. 24, in the forming of the groove using the etchant (operation S230), a second head HD2 may spray an etchant onto the upper surface of the encapsulation substrate 200.

At this time, unlike in the method S1 of manufacturing the display device according to the embodiment described with reference to FIG. 16, etc., the encapsulation substrate 200 used in the method S2 of manufacturing the display device according to the current embodiment may be an encapsulation substrate 200 that has already been slimmed to a second thickness TH2.

Next, as illustrated in FIG. 25, in the injecting of the ink into the groove and the curing of the ink (operation S240), a third head HD3 may inject ink onto the upper surface of the encapsulation substrate 200 and irradiate light such as ultraviolet light or heat.

In the method S2 of manufacturing the display device according to the current embodiment, since a laser patterning process, an etching process and an ink process are performed after the encapsulation substrate 200 and the display substrate 100 are bonded together, processes and equipment used in the existing bonding process can be used as they are. Therefore, process cost can be reduced.

In concluding the detailed description, those skilled in the art will appreciate that many variations and modifications can be made to the presented embodiments without substantially departing from the principles of the present invention. Therefore, the disclosed embodiments are to be used in a generic and descriptive sense only and not for purposes of limitation.

## Claims

1. A display device (10) comprising:
a base substrate (110);
a light emitting element layer (130) on the base substrate (110); and
an encapsulation substrate (200) on the light emitting element layer (130) and covering the light emitting element layer (130),
**characterized in that**
the encapsulation substrate (200) comprises a louver (LV) extending in a direction (DR3) from a first surface of the encapsulation substrate (200) toward a second surface of the encapsulation substrate (200).

2. The display device (10) of claim 1, wherein the encapsulation substrate (200) comprises a groove (GRV) recessed in the direction (DR3) from the first surface of the encapsulation substrate (200) toward the second surface of the encapsulation substrate (200), and the louver (LV) is in the groove (GRV).

3. The display device (10) of claim 1 or 2, wherein
the light emitting element layer (130) comprises first emission areas (EA1), second emission areas (EA2), and third emission areas (EA3),
a third emission area (EA3) of the third emission areas (EA3), a first emission area (EA1) of the first emission areas (EA1) and a second emission area (EA2) of the second emission areas (EA2) are sequentially disposed in one direction (DR5),
the louver (LV) comprises a first louver (LV1) surrounding the third emission area (EA3) in plan view and a second louver (LV2) between the first emission area (EA1) and the second emission area (EA2) in the plan view, and
a size of the third emission area (EA3) is larger than a size of the first emission area (EA1) and a size of the second emission area (EA2).

4. The display device (10) of claim 3, wherein
a distance (D1B) between the first louver (LV1) on a first side of the third emission area (EA3) and the third emission area (EA3) is equal to a distance (D2B) between the first louver (LV1) on a second side of the third emission area (EA3) and the third emission area (EA3).

5. The display device (10) of claim 3 or 4, wherein
a distance (D1R) between the first emission area (EA1) and a portion of the second louver (LV2) between the second emission area (EA2) and the first emission area (EA1) is smaller than a distance (D2R) between the first emission area (EA1) and a portion of the first louver (LV1) between the first emission area (EA1) and the third emission area (EA3),
a height (H1) of the first louver (LV1) is greater than a height (H2) of the second louver (LV2).

6. The display device (10) of at least one of claims 3 to 5, wherein
a portion of the first louver (LV1) is between the first emission area (EA1) and the third emission area (EA3), and
a distance (DR2) between the first emission area (EA1) and the portion of the first louver (LV1) is greater than a distance (D1B) between the third emission area (EA3) and the portion of the first louver (LV1).

7. The display device (10) of at least one of claims 3 to 6, wherein
the size of the first emission area (EA1) is smaller than the size of the second emission area (EA2),
a portion of the second louver (LV2) is between the first emission area (EA1) and the second emission area (EA2), and
a distance (D1R) between the first emission area (EA1) and the portion of the second louver (LV2) between the first emission area (EA1) and the second emission area (EA2) is greater than a distance (D2G) between the second emission area (EA2) and the portion of the second louver (LV2) between the first emission area (EA1) and the second emission area (EA2).

8. The display device (10) of at least one of claims 3 to 7, wherein the louver (LV) does not overlap the first emission area (EA1), the second emission area (EA2), and the third emission area (EA3).

9. The display device (10) of at least one of claims 3 to 7, wherein
at least a portion of the louver (LV) overlaps the third emission area (EA3), optionally wherein the louver (LV) does not overlap the first emission area (EA1) and the second emission area (EA2).

10. The display device (10) of at least one of claims 3 to 9, wherein
the louver (LV) comprises a first light blocking louver (LV21) between the second emission area (EA2) and the first emission area (EA1), a second light blocking louver (LV13) between the first emission area (EA1) and the third emission area (EA3), a third light blocking louver (LV32) between the third emission area (EA3) and the second emission area (EA2), and a fourth light blocking louver (LV33) overlapping the third emission area (EA3),
heights (H2) of the first light blocking louver (LV21), the second light blocking louver (LV13), the third light blocking louver (LV32), and the fourth light blocking louver (LV33) are equal to each other.

11. The display device (10) of claim 10, wherein a distance (D1R) between the first emission area (EA1) and the first light blocking louver (LV21) is equal to a distance (D2R) between the first emission area (EA1) and the second light blocking louver (LV13).

12. The display device (10) of claim 10 or 11, wherein a distance (D1G) between the second emission area (EA2) and the third light blocking louver (LV32) is equal to a distance (D2G) between the second emission area (EA2) and the first light blocking louver (LV33).

13. The display device (10) of at least one of claims 10 to 12, wherein a distance (D1L) between the second light blocking louver (LV13) and the fourth light blocking louver (LV33) is equal to a distance (D2L) between the fourth light blocking louver (LV33) and the third light blocking louver (LV32).

14. The display device (10) of at least one of claims 1 to 13, further comprising:
a polarizing layer (POL) on the encapsulation substrate (200).

15. The display device (10) of claim 14, wherein
the first surface of the encapsulation substrate (200) faces the base substrate (110), and
the second surface of the encapsulation substrate (200) faces the polarizing layer (POL).

16. The display device (10) of claim 14, wherein
the first surface of the encapsulation substrate (200) faces the polarizing layer (POL), and
the second surface of the encapsulation substrate (200) faces the base substrate (110).

17. The display device (10) of at least one of claims 1 to 16, further comprising:
a display substrate (100) including the base substrate (110), a thin-film transistor layer (120) on the base substrate (110), and the light emitting element layer (130) on the thin-film transistor layer (120); and
the encapsulation substrate (200) facing the display substrate (100), wherein
the first surface of the encapsulation substrate (200) is opposite to the second surface of the encapsulation substrate (200),
the encapsulation substrate (200) includes a light control layer (LCL), and
the light control layer (LCL) includes the louver (LV).

18. An automobile comprising:
a windshield (W);
a dashboard (DB) adjacent to the windshield (W); and
at least one display device (10) according to at least one of claims 1 to 17 on the dashboard (DB).
